Europäisches Patentamt

European Patent Office

Office européen des brevets

(19)

(11) **EP 0 687 397 B1**

(12) **EUROPÄISCHE PATENTSCHRIFT**

| | |
|---|---|
| (45) Veröffentlichungstag und Bekanntmachung des Hinweises auf die Patenterteilung:<br>**26.03.1997 Patentblatt 1997/13** | (51) Int Cl.[6]: **H03F 1/32** |
| (21) Anmeldenummer: **94905704.6** | (86) Internationale Anmeldenummer:<br>**PCT/EP94/00202** |
| (22) Anmeldetag: **26.01.1994** | (87) Internationale Veröffentlichungsnummer:<br>**WO 94/21034 (15.09.1994 Gazette 1994/21)** |

(54) **ELEKTRISCHER LEISTUNGSVERSTÄRKER UND VERFAHREN ZU DESSEN BETRIEB**

ELECTRIC POWER AMPLIFIER AND PROCESS FOR ITS OPERATION

AMPLIFICATEUR ELECTRIQUE DE PUISSANCE ET PROCEDE PERMETTANT DE LE FAIRE FONCTIONNER

| | |
|---|---|
| (84) Benannte Vertragsstaaten:<br>**AT CH DE FR GB IT LI LU NL** | (72) Erfinder: **Herrlinger, Jochen**<br>**D-91054 Erlangen (DE)** |
| (30) Priorität: **02.03.1993 DE 4306436**<br>**16.03.1993 DE 4308287** | (74) Vertreter: **Götz, Georg, Dipl.-Ing. et al**<br>**Postfach 11 91 09**<br>**90101 Nürnberg (DE)** |
| (43) Veröffentlichungstag der Anmeldung:<br>**20.12.1995 Patentblatt 1995/51** | (56) Entgegenhaltungen:<br>**DE-A- 3 224 475**      **GB-A- 2 139 031**<br>**US-A- 4 476 442** |
| (73) Patentinhaber: **Naiu, Mircea**<br>**91056 Erlangen (DE)** | |

**Beschreibung**

Die Erfindung richtet sich auf ein Betriebsverfahren und eine Schaltungsstruktur eines elektrischen Leistungsverstärkers, der mehrere Leistungs-Verstärkerelemente (beispielsweise Röhren oder Leistungstransistoren) aufweist, die ausgangsseitig zueinander paarweise komplementär in Gegentakt-B-Betriebsschaltung angeordnet sind, und die eingangsseitig an je eine von dem Eingangssignal des Verstärkers beeinflußte Ansteuerspannung angeschlossen sind, sowie eine oder mehrere Vorspannungsquellen, die ständig zwischen das Eingangssignal des Verstärkers und die Ansteuerspannung mindestens eines Leistungsverstärkerelements gekoppelt ist, um einen möglichst konstanten, durch die Leistungs-Verstärkerelemente fließenden Querstrom zu erzeugen.

In der Leistungsverstärkertechnik sind derartige Verstärkersysteme als Klasse-B-Verstärker (vgl. zum Beispiel Neufang "Lexikon der Elektronik", Braunschweig, 1983, Vieweg-Verlag) bekannt: Zum Beispiel zwei Verstärkerbauelemente (Röhre, Transistor) sind so geschaltet, daß bei einer sinusförmigen Eingangs-Signalspannung ein aktives Bauelement den positiven Anteil der Wechselspannung, das zweite den negativen Anteil übernimmt. Jedes aktive Bauelement führt während einer halben Periode den Laststrom. Der Arbeitspunkt liegt bei jedem der Verstärkerelemente am Ende des geradlinigen Teils der Eingangs-Kennlinie, kurz vor Beginn der Krümmung, fest. Infolge der Eigenart der symmetrisch aufgebauten Schaltung setzen sich die Ausgangs-kennlinienfelder beider aktiven Elemente grafisch so zusammen, daß eine vergrößerte Wechselstromarbeitsgerade entsteht. Im Idealfall dieses Gegentakt-Verstärkerbetriebs liegen positiver und negativer Anteil der Signaleingangsgröße unverzerrt am Signalausgang als vollständiges Sinussignal am Lastwiderstand. Als konkrete Schaltungs-realisierung ist die Anordnung zweier Leistungstransistoren als zueinander komplementäre Emitterfolger im Gegentakt-B-Betrieb bekannt (vgl. Tietze-Schenk "Halbleiter-Schaltungstechnik", Springer-Verlag, 9. Auflage, Seiten 513 ff.), bei der die beiden Leistungstransistoren abwechselnd je eine halbe Periode der Eingangssignalschwingung leitend sind. Nachteilig wirkt sich hier die zum Beispiel bei Silizium-Transistoren auftretende Vorwärtsspannung von 0,7 Volt zwischen Basis- und Emitteranschluß aus, ab der erst ein nennenswerter Kollektorstrom fließt, woraus die an sich bekannten Übernahmeverzerrungen entstehen.

Zur Abhilfe sind Klasse-AB-Verstärker, insbesondere die Anordnung zweier komplementärer Leistungstransistoren jeweils als Emitterfolger im AB-Betrieb, bekannt (vgl. "Lexikon der Elektronik" a.a.O.; "Halbleiter-Schaltungstechnik" a.a.O., Seiten 516 ff.): Läßt man durch beide aktiven Verstärkerelemente, insbesondere Leistungstransistoren, durch Anlegen einer Vorspannung an die Signaleingangselektroden einen kleinen Ruhestrom fließen, verkleinert sich ihr Widerstand in Nullpunktnähe, wobei sich die Übernahmeverzerrungen schon beachtlich vermindern. Bei kleinen Signalansteuerungen stellen sich am Eingang automatisch Betriebsverhältnisse eines an sich bekannten (vgl. angegebene Literaturstellen) Klasse-A-Verstärkers, bei großer Signal-Ansteuerung die Verhältnisse eines Klasse-B-Verstärkers ein. Der Arbeitspunkt wandert auf der Kennlinie zwischen A-Betriebsart, wo der Arbeitspunkt in der Mitte des aussteuerbaren Bereiches der Arbeitskennlinie liegt, und B-Betriebsart, wo der Arbeitspunkt am unteren Ende der Arbeitskennlinie liegt. Zur Erreichung dieses Betriebsverhaltens kann man beispielsweise bei Siliziumtransistoren eine Vorspannung von 0,7 Volt anlegen, so daß die Transistoren auch im Ruhezustand geöffnet sind und kleine Ansteuersignale unverzerrt am Ausgang wiedergegeben werden. Problematisch ist allerdings, den mit der Vorspannung erzeugten Ruhestrom konstant zu halten.

In dieser Hinsicht ist die Maßnahme bekannt, durch Einfügen seriell angeordneter Widerstände zwischen den Leistungsverstärkerelementen, insbesondere Transistor-Emitterfolgern, eine Stromgegenkopplung zu bewirken. Da jedoch die Widerstände in Reihe mit dem angeschlossenen Verbraucher liegen, wird die erhältliche Ausgangsleistung heruntergesetzt.

Ferner ist es bekannt, zur Erzeugung des die Emitter-Kollektor-Strecke der Leistungstransistoren durchfließenden Ruhestroms einen Basisstrom für die Transistoren mittels Konstantstromquellen zu liefern. Damit bei zunehmender Aussteuerung der gelieferte Basisstrom sich vergrößern kann, ist der Einsatz von Feldeffekt-Transistoren in Form von Sourcefolgern bekannt (vgl. Tietze-Schenk "Halbleiter-Schaltungstechnik", Seite 519), bei der sich ihre Source-Spannungsdifferenz durch Stromgegenkopplung auf ca. 1,4 Volt einstellt.

Die GB-A-2 139 031 beschreibt ein Verfahren, welches den Zweck verfolgt, einen Push-Pull-Leistungsverstärker mit zueinander komplementären, in Reihe geschalteten Leistungstransistoren derart zu kompensieren, daß der Querstrom durch die Leistungstransistoren möglichst konstant bleibt. Hierzu sind in die Emitterzweige der beiden Leistungstransistoren Emitterwiderstände zur Stromgegenkopplung eingefügt, deren gemeinsamer Schaltungsknoten über einen weiteren, niederohmigen Widerstand mit dem Ausgangsanschluß der Schaltung verbunden ist. Der Spannungsabfall über diesem Ausgangswiderstand wird durch einen hochohmigen Spannungsteiler abgegriffen und ist über je eine Konstantspannungsquelle, deren Wert etwa dem Spannungsabfall an dem betreffenden Emitterwiderstand bei einem gewünschten Ruhestrom entspricht, mit einem nicht invertierenden Eingang je eines Differenzverstärkers verbunden, dessen invertierender Eingang mit dem Emitteranschluß des betreffenden Leistungstransistors verbunden ist. Der Ausgang dieser beiden Verstärker ist über eine spannungsgesteuerte Stromquelle mit dem Basisanschluß des betreffenden Leistungstransistors verbunden. Damit die Ausgangsspannung dieses Verstärkers einer Eingangsspannung folgen kann, hat jeder der beiden Verstärker einen zusätzlichen, nicht invertierenden Eingang, welcher wahlweise anstelle des bereits beschriebenen, nicht invertierenden Eingangs aktiviert werden kann. Diese Eingänge der beiden Verstärker sind über je eine Konstantspannungsquelle desselben Wertes mit dem Eingangspotential verbunden.

Mit dem Spannungsteiler entlang des Ausgangswiderstands kann die Stromrichtung des Ausgangsstroms bestimmt werden. Ändert sich diese Stromrichtung, indem nun der Ausgangsstrom bspw. in die Schaltung hineinfließt, so würde ohne Kompensation der Emitterstrom des oberen Leistungstransistors bis auf null absinken. Dies wird dadurch verhindert, daß der zugeordnete Verstärker infolge des Absinkens seiner Eingangsspannung an dem invertierenden Anschluß nun auf denjenigen nicht invertierenden Eingang umschaltet, der mit dem Eingangspotential der Schaltung gekoppelt ist. Durch die hier eingeschleifte Konstantspannungsquelle soll erreicht werden, daß der Strom durch den oberen Leistungstransistor einen vorgegebenen Wert nicht unterschreitet.

Da etwa gleichzeitig der andere, untere Verstärker von dem Eingangspotential vollständig abgetrennt wird, muß nun vermittels des oberen Leistungsverstärkers gleichzeitig die Identität zwischen Ausgangs- und Eingangsspannung des Verstärkers sichergestellt werden und darüber hinaus ein Absinken des Ruhestroms vermieden werden. Da jedoch weder die effektive Ausgangsspannung erfaßt wird, noch das Spannungspotential am Fußpunkt des oberen Emitterwiderstandes, steht für eine Rückkopplung weder der tatsächliche Wert der Ausgangsspannung noch ein exakter Meßwert für den Emitterstrom des betreffenden Leistungstransistors zur Verfügung, sondern jeweils nur ein sehr undefinierter Zwischenwert. Es wird zwar das Emitterpotential des betreffenden Leistungstransistors auf einen vorgegebenen Wert geregelt; der tatsächliche Emitterstrom richtet sich jedoch nach dem momentanen Arbeitspunkt des Leistungstransistors wie auch nach dessen Temperatur und kann somit beträchtlich schwanken.

Außerdem werden bei jedem Nulldurchgang des Ausgangsstroms die nicht invertierenden Eingänge der beiden Regelverstärker zwischen dem rückgekoppelten Ausgangssignal und dem Eingangssignal hin- und hergeschaltet. Dies führt insbesondere mit ansteigender Frequenz der zu verstärkenden Spannung zu undefinierten Schaltzuständen, so daß ein Querkurzschluß nicht nur wahrscheinlich, sondern geradezu vorprogrammiert ist. Die Grenzfrequenz dieser Schaltung ist daher relativ gering und wird außerdem dadurch begrenzt, daß die Leistungstransistoren nicht über Spannungs- sondern über Stromquellen angesteuert werden, so daß die parasitären Kapazitäten nur langsam umgeladen werden können.

Die US-PS 4,476,442 offenbart einen Leistungsverstärker mit einer ähnlichen Konfiguration des Leistungsteils, d.h., Leistungstransistoren mit je einem Emitterwiderstand und einem Ausgangswiderstand zwischen deren gemeinsamen Knoten und dem Ausgangsanschluß. Hier wird zwar das Potential an dem gemeinsamen Fußpunkt der beiden Emitterwiderstände abgegriffen wie auch das tatsächliche Ausgangspotential, jedoch nicht das tatsächliche Emitterpotential der beiden Leistungstransistoren. Auch hier kann daher keiner der beiden Emitterströme exakt bestimmt und somit auch nicht auf einen vorgegebenen Ruhestromsollwert geregelt werden. Dies ist auch nicht die Absicht dieser Vorerfindung, die sich vielmehr dem Problem widmet, jeglichen Einfluß der nichtlinearen Kennlinien üblicher Leistungstransistoren aus dem stationären Übertragungsverhalten eines Leistungsverstärkers zu eliminieren. Zu diesem Zweck sind die beiden Basisanschlüsse der beiden Leistungstransistoren über zwei konstante Vorspannungsquellen miteinander verbunden; der gemeinsame Anschluß der beiden Vorspannungsquellen ist mit der Eingangsspannung gekoppelt. Um ein zu der aus den nichtlinearen Basis-Emitter-Spannungen resultierenden Verzerrung proportionales Meßsignal zu erhalten, wird ein Referenzwiderstandsnetzwerk mit drei in Stern geschalteten Widerständen eingefügt, von denen zwei mit dem Basisanschluß je eines Leistungstransistors und der dritte mit dem Ausgangsanschluß des Verstärkers verbunden ist. Die Spannungsabweichung des Bezugsknotens zwischen den beiden Emitterwiderständen und dem Sternpunkt des Referenznetzwerks wird als Indiz für die Spannungsverzerrung verwendet, um einen vorgegebenen Faktor verstärkt als variable Vorspannung zwischen die eigentliche Eingangsspannung und dem gemeinsamen Knoten der beiden konstanten Vorspannungsquellen additiv einzufügen. Da die beiden, mit je einem Basisanschluß eines Leistungstransistors gekoppelten Referenzwiderstände zur exakten Kompensation relativ hochohmig gegenüber dem mit dem Ausgangsanschluß des Leistungstransistors verbundenen Referenzwiderstand sein müssen, entspricht die an dem Rückkopplungsverstärker anliegende Spannung etwa dem Spannungsabfall an dem Ausgangswiderstand der Leistungsendstufe, der wiederum proportional zum Ausgangsstrom ist. Somit wird in Abhängigkeit von dem Wert des Ausgangsstroms die Eingangsvorspannung zu positiven oder negativen Werten hin verschoben, um die stromabhängigen Veränderungen der Basis-Emitter-Spannungen der Leistungstransistoren zu kompensieren. Dieses Verfahren mag zwar bei niedrigen Frequenzen durchaus effizient sein; die notwendigen Umladeströme der parasitären Kapazitäten mit steigender Frequenz können jedoch bei einem derartigen Verfahren nicht berücksichtigt werden, so daß in dem Bereich höherer Frequenzen nach wie vor Verzerrungen auftreten.

Aus diesen Nachteilen des vorbekannten Stands der Technik resultiert das die Erfindung initiierende Problem, weitere, effizientere Möglichkeiten zur Konstanthaltung des Ruhestroms für AB-Betrieb zu eröffnen, wobei die Steuerung des Ruhestroms von der Schwingung des Verstärker-Ausgangssignals entkoppelt ist. Gleichzeitig soll eine möglichst große Bandbreite erzielbar sein.

Zur Lösung wird bei einem Leistungsverstärker-Betriebsverfahren der anfangs genannten Art, wobei der Ruhestrom im Rahmen einer Rückkopplung möglichst konstant auf einem Sollwert gehalten wird, vorgeschlagen, daß die durch die Leistungs-Verstärkerelemente fließenden Ströme sowie der Ausgangsstrom des Leistungsverstärkers durch Meßwertaufnehmer, deren Signalausgänge in Stern geschalten sind, einzeln erfaßt und als Rechenvariable einem Regler zugeführt werden, der daraus nach vorgegebenen Rechenvorschriften Steuersignale für die Vorspannungsquelle(n) generiert, so daß je nach Abweichung des rückgekoppelten Querstroms von einem Sollwert sowie gegebenenfalls zusätzlich abhängig von der Signalfrequenz die Arbeitspunkte der Leistungs-Verstärkerelemente so verstellt werden, daß die Abweichung minimiert wird, wobei das Bezugspotential des Querstromreglers gleich dem Potential des Sternpunkts der Meßwertaufnehmer ist.

Die Arbeitspunkte beider komplementärer Verstärkerelemente werden dabei abhängig von der Frequenz so bewegt, daß der Ruhestrom immer konstant bleibt und dessen Einstellung nicht der Schwingung des (verstärkten) Ausgangssignals folgt. In Konkretisierung dieses Erfindungs-Grundgedankens wird vorgeschlagen, daß die Verstellung der Arbeitspunkte mittels Steuerung der Vorspannungsquellen, beispielsweise Verstellung von deren Steuer-Eingangsspannungen, derart bewirkt wird, daß deren ausgangsseitiger Gleichspannungspegel vergrößert oder verkleinert wird. Mit dem erfindungsgemäßen Verfahren wird also eine echte, flexible Regelung des Ruhestroms erreicht.

Die erfindungsgemäße Regelung des Ruhestroms hat den Vorteil, daß einer frequenzabhängigen Zunahme dieses Ruhestroms wirksam begegnet wird und daher die Bandbreite des Leistungsverstärkers deutlich erhöht wird. Eine solche Regelung ist zwar einerseits höchst wirkungsvoll, andererseits ist der praktische Aufbau jedoch wegen der unterschiedlichen, teilweise in weiten Bereichen schwankenden Spannungspotentiale der Eingangs- und Ausgangssignale sowie wegen der Ermittlung und Verarbeitung von Stromsignalen sehr aufwendig und kann zu einer drastischen Verteuerung des Leistungsverstärkers führen.

Um eine technisch möglichst einfache Realisierung des Leistungsverstärkers zu schaffen, wird bei einer Leistungsverstärkerschaltung der anfangs genannten Art im Rahmen der Erfindung eine Schaltungsstruktur vorgeschlagen mit Meßwertaufnehmern zur Erfassung der durch die Leistungs-Verstärkerelemente fließenden Ströme, deren Signalausgänge in Stern geschalten sind, so daß die durch die Leistungs-Verstärkerelemente fließenden Ströme und der Ausgangsstrom einzeln als Rechenvariable einem Regler zugeführt sind, der daraus nach vorgegebenen Rechenvorschriften Steuersignale für die Vorspannngsquelle(n) generiert, so daß je nach Abweichung des rückgekoppelten Querstroms von einem Sollwert sowie gegebenenfalls zusätzlich abhängig von der Signalfrequenz die Arbeitspunkte der Leistungs-Verstärkerelemente so verstellt werden, daß die Abweichung minimiert wird, wobei das Bezugspotential des Querstromreglers gleich dem Potential des Sternpunkts der Meßwertaufnehmer ist.

Die Meßwertaufnehmer verfälschen die betreffenden Meßgrößen nicht. Darüberhinaus ist eine solche Meßwerterfassung völlig exakt. Dies ist ein Vorteil gegenüber anderen Ausführungsformen, wo insbesondere die durch die Leistungsverstärkerelemente fließenden Ströme durch andere Betriebsparameter der Leistungsverstärkerelemente, wie z.B. Kollektor-Emitter-Spannung oder Basisstrom, ersetzt werden. Die Erfassung anderer Betriebsparameter ist aufgrund der Arbeitspunkt-, Temperatur- und Frequenzabhängigkeit dieser Parameter nicht geeignet, exakte Meßwerte für die durch die Leistungsverstärkerelemente fließenden Ströme zu liefern. Die Leistungsfähigkeit der Ruhestromregelung hängt wesentlich davon ab, daß der Istwert des Ruhestroms exakt erfaßt oder zumindest aus anderen erfaßten Größen exakt bestimmt wird. Eine Schätzung aufgrund anderer, leichter zugänglicher Betriebsparameter ist hierfür nicht ausreichend.

Durch die Sternschaltung der Meßwertaufnehmer ist es möglich, die Ausgangssignale sämtlicher Meßwertaufnehmer auf ein gemeinsames Potential, nämlich dasjenige des Sternpunkts, zu beziehen. Dies erleichtert die weitere Verarbeitung der Meßsignale im Rahmen der Ruhestromregelung. Sensiert der Regler beispielsweise eine Erhöhung des Ruhestroms, verringert er die an den Signaleingangselektroden der Leistungsverstärkerelemente anliegende Spannung, was eine Veränderung von deren "statischen" Arbeitspunkten zur Folge hat. Eine Anordnung, bei der das Bezugspotential des Ruhestromreglers gleich dem Potential des Sternpunkts des Meßwertaufnehmers ist, weist den Vorteil auf, daß für die Weiterverarbeitung durch die Analogschaltung des Ruhestromreglers auf dessen Nullpotential bezogene, zu dem betreffenden Stromsignal proportionale Meßsignale zur Verfügung stehen. Eine weitere Pegelverschiebung oder Entzerrung ist nicht erforderlich.

Als zweckmäßige Realisierung der Stelleinrichtung "Vorspannungsquelle" für die zu regelnde Größe "Verstärkerelemente-Ruhestrom" eignet sich zweckmäßig ein vom Regler angesteuerter, vorzugsweise mehrstufiger Kleinsignalverstärker, der mit dem Regler auch baulich integriert sein kann. In besonderer Konkretisierung dieses Gedankens sind zwei jeweils vom Regler angesteuerte Kleinsignalverstärker-Zweige vorgesehen, die je einem der paarweise komplementären Leistungsverstärkerelementen zugeordnet sind.

Mit Vorteil ist der Regler zwischen den paarweise komplementären Leistungsverstärkerelementen angekoppelt und besitzt einen eigenen Leistungssignal-Ausgang, mittels dem die (summierten) Ausgangsströme der Verstärkerelemente herausgeschleift werden. Der Vorteil besteht darin, daß an diesem Leistungssignal-Ausgang des Reglers ein oder mehrere weitere Leistungs-Verstärkerelementepaare parallel angeschaltet werden können, wobei jedes Leistungs-Verstärkerelement vom Regler kontrolliert sein kann. Hierdurch wird die Möglichkeit geschaffen, die Leistungs-kapazität am Ausgang des erfindungsgemäßen Verstärkersystems je nach Bedarf und Anwendungsfall durch paralleles Anschalten solcher Erweiterungsstufen bzw. -module, jeweils in Gegentakt-B-Betriebsschaltung, modular bzw. flexibel zu verändern. Zur Kontrolle der Erweiterungsstufe durch den Regler ist ein dazwischen angeordnetes Koppelglied zweckmäßig, das vorteilhaft als Impedanzwandler und/oder vom Regler kontrolliertes, aktives Steuerelement realisiert ist. Diese Steuerelemente bzw. Impedanzwandler können je einem der paarweise komplementären Leistungsverstärkerelemente positiver bzw. negativer Polarität zugeordnet sein und an aus dem Regler herausgeführte Kontroll-Leitungen parallel anliegen, die so einen vorzugsweise angepaßten Analogbus bilden.

Mit Vorteil sind die Ausgangssignale des Reglers derart komplementärsymmetrisch gegliedert, daß sie hälftig den Leistungsverstärkerelementen jeweils positiver und negativer Polarität bzw. Betriebsspannung zugeordnet sind. Hierdurch wird eine übersichtliche Schaltungsstruktur erzielt.

Zur schaltungstechnischen Realisierung der Erfassung der Sollwert-Abweichung für den Regler wird eine Ausbildung der Erfindung vorgeschlagen, nach der im Regler baulich eine Referenz-Spannungs- oder eine Referenz-Stromquelle sowie ein Verknüpfungsglied, insbesondere ausgeführt als Vergleichselement, integriert sind, wobei letzteres an die Referenz-Quelle und an den Leistungsverstärkerelemente-Ruhestrom zur Bestimmung der Sollwertabweichung angeschlossen ist.

Die Anwendung verfeinerter Regelkonzepte bzw. -strategien läßt sich durch den Einsatz eines Analogrechners bzw. -computers als Regler fördern. Damit können - in weiterer Ausbildung der Erfindung - Ruhestrom-Steuersignale erzeugt werden, wenn der Analogrechner Vergleichs- oder Summier-Rechenschaltungen für den Leistungsverstärkerelemente-Ruhestrom und den Referenzstrom aufweist, und der Summier-schaltung eine Multiplizierschaltung nachgeordnet ist, die eine Multiplikation mit einer Konstanten realisiert. Das Ruhestrom-Steuersignal kann vorteilhaft mit dem Verstärker-Nutzsignal an einem anderen Punkt innerhalb des Verstärker-Systems, beispielsweise im Rahmen der Vorspannungserzeugung mittels Kleinsignalverstärkung, gemischt werden.

Ferner ist der Einsatz eines Analog rechners als Kernstück der Verstärkerschaltung dafür nützlich, Rückkopplungs-signale nach spezifizierten Rechenvorschriften zu erzeugen. So können die Rückkopplungssignale nach bestimmten mathematischen Funktionen, beispielsweise der Verstärker- bzw. Regler-Ausgangsspannung, des durch ein aktives Verstärkerelement fließenden Stroms, des obengenannten Ruhestrom-Steuersignals usw. erzeugt werden. Die Rückkopplungssignale werden dann mit besonderem Vorteil der obengenannten Kleinsignalverstärkerstufe zugeführt, die solchenfalls zweckmäßig als Differenzverstärker ausgeführt ist.

In entsprechender Weise läßt sich der Analogrechner dafür verwenden, durch Verknüpfung von Rechenschaltungen für Addition, Multiplikation usw. Ausgangssignale zu erzeugen, die zu dem obengenannten Analogbus für die obengenannten Leistungs-Baugruppen zusammengefaßt sein können. Darüber hinaus ergibt sich mit dem erfindungsgemäßen Einsatz des Analogrechners die Perspektive, ein aus der Ausgangs-spannung und einer Fehlerspannung für den Ruhestrom bestehendes Rückkopplungssignal für die Vorspannungserzeugung bzw. den entsprechenden Kleinsignalverstärker zu generieren. Außerdem besteht eine zweckmäßige Weiterbildung darin, den Analogrechner den Leistungsverlust der aktiven Leistungsverstärkerelemente berechnen zu lassen und im Fall einer Überschreitung maximaler Grenzwerte die Endleistungs-stufe gegen Überlastung zu schützen.

Es hat sich als günstig erwiesen, daß die Meßwertaufnehmer in den jeweiligen Stromkreis eingeschaltete, ohmsche Widerstände sind. Solche Meßwiderstände stellen die einfachsten und gleichzeitig vollwertigen Meßwertaufnehmer dar, welche die betreffenden Ströme in dazu proportionale Spannungssignale umsetzen, welche wiederum von dem Ruhestromregler verarbeitet werden können.

Bei dieser Ausführungsform besteht eine günstige Weiterbildung darin, daß die freien Anschlüsse der Meßwiderstände mit den Ausgängen der Leistungs-verstärkerelemente einerseits sowie mit dem Ausgang des Leistungsverstärkers andererseits verbunden sind. Bei der Verwendung von Meßwiderständen als Meßwertaufnehmer ist zu beachten, daß Signalein- und -ausgänge identisch sind. Aus diesem Grund muß je ein Anschluß der Meßwiderstände zu einem gemeinsamen Sternpunkt verbunden werden, um ein gemeinsames Bezugspotential für die Signalausgänge zu erhalten. Eine Sternschaltung ist jedoch nur am Ausgangsknoten des Leistungsverstärkers möglich. Deswegen werden die freien Anschlüsse zweier Meßwiderstände mit den Ausgängen der Leistungsverstärkerelemente verbunden, während der freie Anschluß des dritten Meßwiderstandes den Ausgang des Leistungsverstärkers bildet. Somit liegen zwischen den beiden Leistungsverstärkerelementen zwei Meßwiderstände in Reihe, an deren Verbindungsknoten ein dritter, vom Ausgangsstrom durchflossener Meßwiderstand angeschlossen ist. Die

9     EP 0 687 397 B1     10

Ausgangsspannung des Leistungsverstärkers wird durch diese Meßwiderstände nur unwesentlich verändert. Falls jedoch diese nur geringfügigen Veränderungen nicht klein genug sind, kann das Ausgangssignal am freien Ende des betreffenden Meßwiderstands zurückgeführt und durch eine Spannungsregelung höchst präzise dem idealen Verlauf nachgeführt werden.

Wenn das Potential des Ruhestromreglers mit dem Potential des Sternpunkts des Meßwertaufnehmers gekoppelt ist, so muß es nahezu den vollen Spannungshub des Ausgangssignals vollführen. Wegen dieses schwankenden Bezugspotentials wird es erforderlich, zusätzliche Versorgungsspannungen für den Ruhestromregler vorzusehen, welche gegenüber dem als Bezugspotential dienenden Potential des Sternpunkts der Meßwertaufnehmer konstant gehalten werden.

Zur Weiterverarbeitung der solchermaßen erfaßten Stromistwerte sieht die Erfindung eine Analogschaltung innerhalb des Ruhestromreglers vor, die aus den Meßsignalen für die durch die Leistungsverstärkerelemente fließenden Ströme sowie für den Ausgangsstrom des Leistungsverstärkers ein zum Ruhestrom proportionales Meßsignal bildet. Dieser einen Kernpunkt des Ruhestromreglers bildende Teil der Analogschaltung kann gemäß unterschiedlicher Algorithmen realisiert sein. Eine Möglichkeit besteht darin, die Meßsignale für die Ströme durch die beiden Verstärkerelemente, welche aufgrund der Symmetrie zu dem Sternpunkt entgegengesetze Polarität aufweisen, voneinander zu subtrahieren, hiervon den Betrag des Meßsignals für den Ausgangsstrom zu subtrahieren und das Ergebnis durch zwei zu teilen. Solche Additions-, Subtraktions- sowie Multiplikationsschaltungen sind seit langem bekannt und lassen sich mit Hilfe von Operationsverstärkern problemlos aufbauen.

Gemäß der vorliegenden Erfindung umfaßt der Ruhestromregler weiterhin eine Subtraktionschaltung zur Bildung der Differenz zwischen dem zum Ruhestrom proportionalen Rechensignal und einem konstanten Ruhestrom-Sollwert. Eine solche Subtraktion ist elementarer Bestandteil jedes Proportionalreglers und ermöglicht einen Vergleich von Soll- und Istwert des Ruhestroms, wobei die Stellgröße proportional zu dieser Differenz verstellt wird.

Zur Anpassung des Reglerausgangssignals an den Stellbereich der beinflußten Stellgröße sowie zur Optimierung des Reglerverhaltens sieht die Erfindung vor, daß zur Bildung des Reglerausgangssignals das zur Differenz zwischen Ruhestromsoll- und -istwert proportionale Rechensignal mit einem Faktor multipliziert, insbesondere verstärkt wird. Der Multiplikationsfaktor beeinflußt die Güte der Regelung sowie die bleibende Regelabweichung und hat darüberhinaus auch Einfluß auf die Stabilität des Regelkreises. Aus diesem Grund ist es sinnvoll, die konkreten Multiplikations- oder Verstärkungsfaktoren experimentell zu bestimmen.

Es hat sich als günstig erwisen, daß das Ausgangssignal des Ruhestromreglers zur Bildung des Ansteuersignals für eines der Leistungsverstärkerelemente dem gegebenenfalls vorverstärkten Verstärkereingangs- oder Spannungsreglerausgangssignal näherungsweise additiv oder subtraktiv überlagert wird. Da die Leistungsverstärkerelemente im allgemeinen von Leistungstransistoren mit drei Anschlüssen - Kollektor, Basis, Emitter - repräsentiert werden, steht als Stellgröße im allgemeinen nur das Eingangssignal an einem Steuereingang, üblicherweise der Basis, zur Verfügung. Denn einer der beiden Leistungsanschlüsse ist zumeist mit einer der beiden Versorgungsspannungen verbunden, während der andere Leistungsanschluß den Ausgang bildet. Um ein möglichst lineares und damit überschau- und berechenbares Verhalten des Ruhestromregelkreises zu erhalten, wird das Ausgangssignal des Ruhestromreglers dem zu verstärkenden Eingangssignal des Verstärkers oder dem Ausgangssignal eines übergeordneten Spannungsreglers linear überlagert. Da auf diese Art nur das Ansteuersignal eines der beiden Leistungsverstärkerelemente beeinflußt wird, kann ein übergeordneter Spannungsregler die Ausgangsspannung des Leistungsverstärkers dennoch exakt ausregeln.

Ohne Beeinträchtigung des Regelverhaltens eines übergeordneten Spannungsreglers ist es auch möglich, zur Verbesserung der Ruhestromregelung das Ausgangssignal des Ruhestromreglers zur Bildung des Ansteuersignals für das andere Leistungsverstärkerelement dem gegenbenenfalls vorverstärkten Eingangssignal oder dem Reglerausgangssignal eines übergeordneten Spannungsregelkreises mit umgekehrter Polarität zu überlagern. Wenn im Idealfall somit die Ansteuersignale für die beiden Leistungsverstärkerelemente um exakt den selben Betrag in umgekehrter Richtung verstellt werden, so wird hierdurch die Ausgangsspannung des Leistungsverstärkers überhaupt nicht beeinflußt, so daß die übergeordnete Spannungsregelung nahezu unabhängig von der Ruhestromregelung ist.

Da somit bei beiden zuvor beschriebenen Ausführungsformen unterschiedliche Ansteuersignale für die beiden Leistungs-verstärkerelemente erzeugt werden müssen, wird es erforderlich, getrennte Ansteuerstufen für die beiden Leistungsverstärkerelemente vorzusehen. Während in einer der beiden Ansteuerstufen das Eingangssignal mit dem Ausgangssignal des Ruhestromreglers linear überlagert wird, findet in der anderen Ansteuerstufe entweder keine Überlagerung oder eine Überlagerung mit umgekehrter Polarität des Ruhestromreglerausgangssignals statt.

Zur Realisierung der linearen Überlagerung von Verstärkereingangs- oder Spannungsreglerausgangssignal mit dem Ruhestromreglerausgangssignal sieht die Erfindung vor, daß der oder die Ausgangstransistoren der mit dem Ausgangssignal des Ruhestromreglers gekoppelten Ansteuerstufe(n) in Emitterschaltung betrieben sind und die Überlagerung von Verstärkereingangs- oder Spannungsreglerausgangssignal mit dem Ruhestromreglerausgangssignal durch Stromgegenkopplung vermittels eines in den Emitterkreis des Transistors geschalteten Emitterwiderstands erfolgt, der zusätzlich zum Emitterstrom des Ansteuertransistors einen zum Ausgangssignal des Ruhestromreglers proportionalen Regelstrom führt. Wegen der großen Potentialunterschiede zwischen dem Eingangssignal des Leistungsverstärkers oder des Ausgangssignals eines überlagerten Spannungsreglers gegenüber dem Ansteuerpotential für die Leistungsverstärkerelemente einerseits sowie des Potentials des Ruhestromreglers gegenüber den Ansteuersignalen der Leistungsverstärkerelemente andererseits ist es sinnvoll, die betreffenden Verstärkereingangs- und/oder Reglerausgangssignale in dazu proportionale, potentialunabhängige Stromsignale umzuwandeln. Ein solches Stromsignal läßt sich durch einen auf geeignetem Potential eingeschalteten Widerstand in einen Spannungshub zurückverwandeln, der sodann das Ausgangssignal der Ansteuerstufe beeinflußt. Wenn dieses Spannungssignal zur Ansteuerung der Basis eines in Emitterschaltung betriebenen Ausgangstransistors der Ansteuerstufe verwendet wird, ist es möglich, einen Gegenkopplungswiderstand in den Emitterkreis dieses Transistors zu schalten. Bei geeigneter Dimensionierung der Ansteuerstufe wird die Spannung an diesem Gegenkopplungswiderstand näherungsweise identisch zur Spannung an dem Eingangswiderstand der Ansteuerstufe, so daß der Strom durch diesen Emitterwiderstand proportional zum Eingangsstromsignal der Ansteuerstufe ist. Man spricht in einem solchen Fall auch von Stromspiegel. Nun kann das Ausgangssignal dieser Ansteuerstufe, nämlich das Potential am Kollektor des Ausgangstransistors, weiterhin dadurch beeinflußt werden, daß der betreffende Emitterwidestand durch einen zusätzlichen, zum Ausgangssignal des Ruhestromreglers proportionalen Strom durchflossen und die Stromgegenkopplung dadurch je nach Polarität verstärkt oder vermindert wird. Hierduch findet näherungsweise eine Stromaddition oder -subtraktion in dem Emitterwiderstand statt, welche das Ausgangssignal der Ansteuerstufe entsprechend beeinflußt und somit eine Nachführung des Arbeitspunkts des Leistungsverstärkerelements ermöglicht.

Zur Einkopplung des Ausgangssignals des Ruhestromreglers in den Emitterwiderstand der Ansteuerstufe sieht die Erfindung vor, daß das zur Differenz zwischen Ruhestromsoll und -ist wert proportionale Rechensignal in einem Differenzverstärker verstärkt wird, von dessen Kollektorwiderständen einer identisch mit dem der Stromgegenkopplung dienenden Emitterwiderstand der Ansteuerstufe ist. Ein solcher Differenzverstärker erfüllt dadurch mehrere Aufgaben: Das zur Differenz zwischen Ruhestromsoll- und Ruhestromistwert proportionale Rechensignal wird verstärkt, um ein optimales Reglerverhalten zu erreichen. Darüberhinaus wird das Reglerausgangssignal dem eingeprägten Gleichstrom des Differenzverstärkers überlagert und dadurch in ein proportionales Stromsignal umgewandelt, welches eine Potentialverschiebung ermöglicht. Schließlich wird dieses Stromsignal an dem mit dem Gegenkopplungswiderstand der Ansteuerstufe identischen Kollektorwiderstand in ein Spannungssignal wieder zurückverwandelt, welches das Ausgangssignal der Ansteuerstufe beeinflußt.

Schließlich entspricht es der Lehre der Erfindung, daß jede Ansteuerstufe aus zwei komplementären, in Emitterschaltung angeordneten sowie im Gegentakt betriebenen Transistoren mit je einem Emitterwiderstand gebildet ist, wobei diese Emitterwiderstände identisch mit den Kollektorwiderständen je eines Zweigs von symmetrisch zum Bezugspotential des Ruhestromreglers angeordneten Differenzverstärkern sind. Zur Erhöhung der Effektivität der Schaltung, d.h. zur Verbesserung des Regelverhaltens sowie auch zur Verminderung des Stromverbrauchs sieht die Erfindung vor, daß jede Ansteuerstufe zwei komplementäre, in Gegentakt-B-Betriebsschaltung arbeitende Transistoren aufweist, deren Ausgangsanschluß - gegebenenfalls durch Zwischenschaltung eines Treibers - den Steuereingang eines Leistungsverstärkerelements ansteuert. Jede Ansteuerstufe weist somit zwei zueinander komplementäre Ausgangstransistoren auf, in deren Emitterkreis je ein Gegenkopplungswiderstand eingeschalten ist. Wegen des symmetrischen Aufbaus einer solchen Ansteuerstufe ist es möglich, an beiden Gegenkopplungswiderständen ein zum Ruhestromreglerausgangssignal proportionales Stromsignal einzukoppeln. Wegen der bezüglich des Bezugspotentials des Ruhestromreglers umgekehrten Polarität des Stromflusses durch diese beiden Gegenkopplungswiderstände sind hierfür jedoch am Ausgang des Ruhestromreglers zwei Differenzverstärker mit zum Bezugspotential des Ruhestromreglers symmetrischem Aufbau notwendig. Da die Ausgangssignale eines Differenzverstärkers sich gegensinnig ändern, ist durch den jeweils anderen Ausgang eine Gegenkopplung der zweiten Ansteuerstufe möglich, so daß mit den vier Ausgängen der beiden Differenzverstärker je einer der vier Emitterwiderstände der beiden Ansteuerstufen gekoppelt ist.

Weitere Einzelheiten, Merkmale, Vorteile und Wirkungen auf der Basis der Erfindung ergeben sich aus den Unteransprüchen sowie der nachfolgenden Beschreibung bevorzugter Ausführungsbeispiele der Erfindung anhand der Zeichnungen. Diese zeigen in :

Fig. 1 und 2     zwei Leistungsverstärkerschaltungen, wie an sich aus dem Stand der Technik bekannt,

Fig. 3     ein Strom-Zeit-Diagramm,

Fig. 4     ein Blockschaltbild der Schaltungsstruktur des erfindungsgemäßen Verstärkersystems,

Fig. 5     die Schaltungsstruktur einer Analogbus-Erweiterungsstufe, und

Fig. 6          ein Schnittstellen-Blockschaltbild des erfindungsgemäß eingesetzten Analogrechners.

Fig. 7          einen Leistungsverstärker mit zwei Leistungsverstärkerelementen, diesen zugeordneten Ansteuerstufen sowie einer überlagerten Regelung der Ausgangsspannung, bei dem Anschlußmöglichkeiten für die Eingangs- und Ausgangssignale eines Ruhestromreglers vorgesehen sind,

Fig. 8          einen erfindungsgemäßen Ruhestromregler, welcher an die betreffenden Signalanschlüsse des Leistungsverstärkers aus Fig. 7 anzuschließen ist sowie

Fig. 9          ein Zeitdiagramm mit einem beispielhaften Verlauf der Eingangssignale des Ruhestromreglers aus Fig. 8.

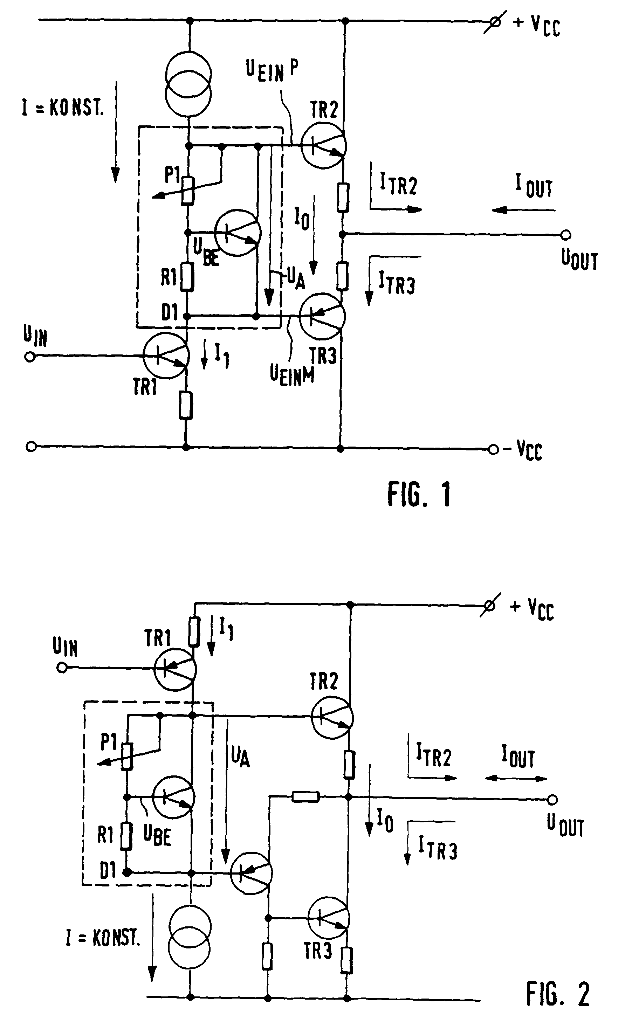

Es ist bekannt, in den Endstufen von Verstärkern verschiedene Versionen einer Verknüpfung zweier Spannungsfolger einzusetzen. Zwei solcher Standardgrundstufen sind in den Fig. 1 und 2 dargestellt. Für Hochleistung und/oder hohen Ausgangsstrom haben diese an sich bekannten Stufen allerdings ihre Grenzen:

Um Übernahmeverzerrungen zu vermindern, ist das sogenannte Superdioden-Netzwerk D1 so eingestellt, daß ein Ruhestrom I0 durch die als zueinander komplementäre Emitterfolger angeordneten Transistoren TR2 und TR3 fließt. Gewöhnlich beträgt der Ruhestrom I0 für Leistungsverstärker 50 - 160 Milliampere. Dieser Ruhestrom führt allerdings zu einem unerwünschten Leistungsverlust in den Transistoren TR 2 und TR3. Das Superdioden-Netzwerk D1 simuliert den direkten Spannungsabfall einer Diode, multipliziert mit einer beliebigen Zahl > 1:

$$U_a = (1+P1/R1) \times U_{BE}$$

Der Zweck ist, die Transistoren TR 2 und TR3 (Fig. 1) leicht zu öffnen. Das bedeutet, daß die Spannung $U_A$ etwas größer sein muß als $2 \times U_{BE}$. $U_A$ ist eigentlich die gemessene Spannung zwischen den beiden Basiselektroden der komplementären Leistungstransistoren TR2 und TR3.

Die Übernahmeverzerrungen hängen von dem Wert des Ruhestroms I0 und von der Frequenz des zu verstärkenden Signals ab. Bei höherer Frequenz werden auch die Verzerrungen größer. Folglich können die komplementären Transistoren TR2 und TR3 nicht unverzüglich nach dem Ausschalten wieder in den Einschaltzustand geführt werden und umgekehrt. Dies hat zur Folge, daß die Verzerrungen bei höheren Frequenzen größer sind. Wenn die Frequenz einen zu hohen Wert erreicht hat, vergrößert sich der Ruhestrom, wobei die Transistoren TR2 und TR3 zerstört werden können; denn für bestimmte Halbleiter ist die zeitliche Abstimmung der Einschaltdauer "$t_{ON}$" und der Ausschaltdauer "$t_{OFF}$" verschieden. Alle Vorkehrungen zum Schutz gegen einen Überstrom können nicht verhindern, daß bei einer gewissen Frequenzhöhe die Transistoren TR2 und TR3 zerstört werden.

Die Frequenzbandbreite solcher bekannter Verstärker-schaltungen ist gewöhnlich nicht nur wegen der obengenannten Problempunkte beschränkt, sondern auch wegen des Umstands, daß die Eingangssteuerstufe TR1 der vollen Schwingung der Ausgangsspannung folgen sollte. Dabei ist nur ein begrenzter, konstanter Strom I1 vorhanden, um die Streukapazität zu laden.

Für gute Ergebnisse müssen bei der an sich bekannten Verstärkerschaltung die Endleistungstransistoren gepaart sein, was umsomehr gilt, wenn eine Parallelschaltung der Leistungstransistoren für größere Leistungen benötigt wird.

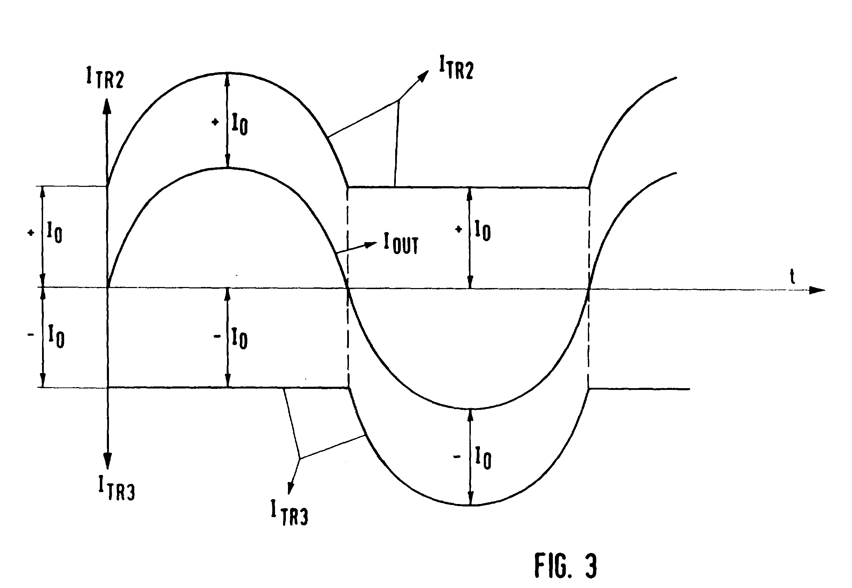

Die erfinderische Idee, die soeben aufgezeigten Problempunkte zu überwinden, besteht in der Kontrolle des Ruhestroms durch eine Rückkopplung, die eigentlich die Ausgangsstufe der Klasse B in eine echte Ausgangsstufe der Klasse A umwandelt, obwohl die Hardwarekonfiguration im Grund eine Ausgangsstufe der Klasse B bleibt. Die Rückkopplung agiert so, daß die Transistoren TR2 und TR3 niemals ausgeschaltet werden. Fig. 3 zeigt den grund-sätzlichen Stromfluß in der errichteten Endstufe bei einem sinusförmigen Ausgangssignal. Diese Lösung kann in allen Arten von Verstärkern, integriert oder nicht, angewendet werden. Die Vorteile dieser Stufe sind wie folgt :

Die Übernahmeverzerrung ist drastisch reduziert, wenn nicht sogar verschwunden, weil die nach dem Verfahren gemäß Fig. 3 betriebene Stufe nach der A-Betriebsart bzw. wie ein Klasse-A-Verstärker funktioniert. Der Ruhestrom kann viel kleiner sein als in bisher bekannten Stufen. Theoretisch ist es möglich, daß der Ruhestrom I0 den Nullwert annimmt. Infolgedessen wird der Ruheleistungsverlust drastisch reduziert.

Die Bandbreite ist mit dem erfindungsgemäßen Betrieb viel größer, weil sich der "statische" Arbeitspunkt der Transistoren TR2 und TR3 abhängig von der Frequenz so bewegt, daß I0 immer konstant bleibt und die Steuerung nicht der Schwingung der Ausgangsspannung folgt.

Beim Schaltkreis nach Fig. 1 oder 2 ist die Kollektorspannung des Eingangstransistors TR1 eine Funktion der Eingangsspannung $U_{IN}$. Wenn die Verstärkung der Treiber-stufe TR1 $A_U$ ist, dann gilt für die Kollektorspannung

$$U_{TR1} = -A_U \times U_{IN}.$$

Praktisch kann die Kollektorspannung wegen der Sättigungs-spannung des Transistors TR1 und der Sättigungs-spannung der Stromquelle nur Werte knapp unter den Speise-spannungen haben.

In jedem Schaltkreis entstehen Streukapazitäten. Normalerweise sind diese Streukapazitäten klein genug, um in dem niedrigen Frequenzbereich keinen großen Einfluß auszuüben. Im hohen Frequenzbereich sieht dies anders aus. Die Spannung an den (fiktiven) Kondensatorklemmen ist direkt proportional zur elektrischen Ladung Q und umgekehrt proportional zur Kapazität des Kondensators. Man kann nun sagen, daß die Spannung an den Klemmen des fiktiven Kondensators nur so schnell schwanken kann, wie die elektrische Ladung im Kondensator verändert werden kann. Die Ladung ist aber abhängig vom Produkt aus Strom und Zeit. In unserem Beispiel ist der durch den Eingangs-transistor TR1 fließende Strom I1 konstant. Die Schnellig-keit der Spannungsschwankungen am Kollektor des Eingangs-transistors bzw. der Treiberstufe TR1 kann (unter anderem) durch Vergrößerung des durchfließenden Stroms I1 und/oder Verkleinerung der Streukapazitäten erhöht werden. Für einen Schaltkreis sind die Streukapazitäten gegeben, und der Strom I1 des Eingangstransistors TR1 kann kaum vergrößert werden, wenn nicht der Eingangstransistor TR1 ein Leistungstransistor sein soll, wodurch seine eigene maximale Arbeitsfrequenz niedriger wird.

Um am Ausgang der Verstärkerschaltung die maximalen Spannungsschwankungen zu erreichen (bis hin zu den Speise-spannungen +/- $V_{CC}$) muß die Eingangstreiberstufe TR1 so viel schwanken, weil die komplementären Leistungstransistoren als Spannungsfolger bzw. Emitter-folger die Spannungsverstärkung A = 1 besitzen.

Eine andere Möglichkeit wäre, daß die Treiberstufe nicht mit der ganzen Ausgangsspannungsschwankung arbeitet. Eine solche Lösung läßt sich ebenfalls in Fig. 1 veranschaulichen:

Wie die Steuerspannungen $U_{EIN}P$ und $U_{EIN}M$ entstehen, ist unwichtig. Wichtig ist, daß deren Schwankungen sehr gering sind. Damit wird die Bandbreite wenigstens vom Konzept der Treiberstufe nicht begrenzt. Außerdem erleichtert das Konzept die Steuerung durch einen Analogrechner (siehe unten).

Die Bewegung der "statischen" Arbeitspunkte der Leistungs-transistoren TR2 und TR3 in Abhängigkeit von der Frequenz basiert auf dem erfindungsgemäßen Konzept:

Im Ruhezustand haben die Steuerspannungen $U_{EIN}P$ und $U_{EIN}M$ einen Gleichspannungspegel, der die Leistungstransistoren TR2 und TR3 leicht öffnet, so daß ein Ruhestrom I0 fließen kann. Wenn der Verstärker gesteuert wird, bestehen die Steuerspannungen $U_{EIN}P$ und $U_{EIN}M$ aus einer Mischung aus dem Nutzsignal und dem Gleichspannungspegel. In bisher bekannten Verstärkern ist dieser Gleichspannungspegel konstant, was zur Folge hat, daß die Leistungstransistoren TR2 und TR3 nur im Ruhezustand oder kurz beim Null-Übergang beide gleichzeitig geöffnet werden. Dies führt zu Übergangsverzerrungen. Erfindungsgemäß dagegen wird der Gleichspannungspegel nicht konstantgehalten, sondern vom weiter unten erläuterten Analogrechner geregelt. Mit Erhöhung der Frequenz verursacht die in der Basis-Emitter-Übergangsschicht akkumulierte elektrische Ladung eine weitere Öffnung der Transistoren TR2 und TR3. Dies hat die Tendenz der Erhöhung des Ruhestroms I0 zur Folge. Der Analogrechner sensiert jedoch die Erhöhung des Ruhestroms und verringert die Gleichspannungskomponenten an den Leistungstransistor-Eingangselektroden $U_{EIN}P$ und $U_{EIN}M$, so daß sich die "statischen" Arbeitspunkte - beim Betrieb nach der Erfindung - verändern.

Praktisch ist es unmöglich, daß die Leistungstransistoren TR2 und TR3 zerstört werden, wenn die Frequenz sich vergrößert. Denn der Strom I0 ist durch den Analogrechner geregelt und kann so einen Sollwert nicht überschreiten. Mit anderen Worten, die Transistoren TR2 und TR3 sind zu jedem Zeitpunkt und auf jedem Punkt der Arbeits-gerade/Ellipse gleichzeitig geöffnet, wobei der Grad der Öffnung vom Analogrechner gesteuert wird. Während also ein Transistor nicht nur den Laststrom, sondern noch zusätzlich den Ruhestrom I0 leitet, ist der andere, komplementäre Leistungstransistor nur vom Ruhestrom I0 durchflossen und umgekehrt. Kein Transistor gerät jemals in den Sperrzustand. Es entsteht also ein echter Klasse-A-Verstärkerbetrieb.

Die Leistungstransistoren könnten verschiedene Eigen-schaften haben. Die Produktionstoleranzen haben keinen Einfluß auf die Verstärkerqualität und -leistung. Eine Selektion oder Paarung der Leistungstransistoren ist nicht notwendig. Die erfindungsgemäß erzielte, hohe Gleichtakt-unterdrückung macht es möglich, den Ruhestrom auf einen sehr kleinen Wert zu reduzieren.

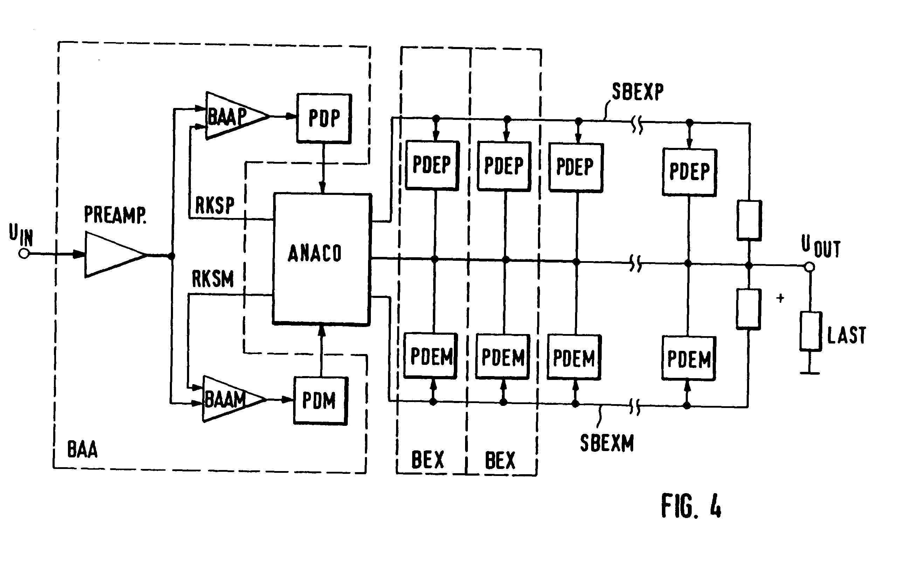

Gemäß Fig. 4 besteht das erfindungsgemäße Verstärkungssystem aus drei wesentlichen Teilen:

Der Grundverstärker BAA weist einen Vorverstärker PREAMP und zwei getrennte Endverstärker BAAP und BAAM auf, einen für die "Plus"-Seite - BAAP, und einen für die "Minus"-Seite - BAAM. Diese zwei jeweils vom Eingangs-Vorverstärker PREAMP getriebenen Endverstärker BAAP, BAAM steuern getrennt die jeweiligen Leistungstransistoren PDP, PDM für die "Plus"-Seite und die "Minus"-Seite. Jeder der End-verstärker BAAP, BAAM hat seine eigene Rückkoppelung. Sie können beispielsweise mit Differenz-, insbesondere Operationsverstärkern, verwirklicht sein.

In bisher bekannten Verstärkerschaltungen wird eine Erhöhung der Leistung durch Parallelschaltung mehrerer Transistoren in der Endstufe gewährleistet. Die Leistung, und damit die Anzahl der parallel zu schaltenden Transistoren, muß allerdings von Anfang an festgelegt sein. Zur Steuerung mehrerer, parallel geschalteter, bipolarer Leistungstransistoren müssen zusätzlich ein oder mehrere Steuertransistoren eingebaut werden. Bei MOSFET-Leistungstransistoren mit Parallelschaltung ist die gesamte Eingangskapazität ein Produkt zwischen der Eingangskapazität eines Transistors und der Zahl der parallel geschalteten Transistoren. Dies macht die Steuerung bei Hochfrequenz schwer, abgesehen von Stabilitätsproblemen. Das Problem besteht darin, daß sie in der direkten Verstärkungskette eingebaut sind. Dadurch entstehen zusätzliche Phasenverschiebungen, die die Notwendigkeit stärkerer Kompensation des Verstärkers zur Folge hat. Damit geht jede Flexibilität verloren, und jede Erweiterung/Änderung kann zu Stabilitätsproblemen führen.

Erfindungsgemäß besteht die Idee darin, einen Grundverstärker BAA zu haben, der bedingungslos stabil ist (es gibt auch bedingte Stabilität). Dabei ist es möglich, gemäß Fig. 4 so viele Leistungstransistoren PDEP, PDEM parallel zu schalten, wie für die erforderliche Leistung nötig sind. Dies ist möglich, weil die zusätzlichen Leistungstransistoren PDEP, PDEM erfindungsgemäß einzeln stromgesteuert sind. Jede Erweiterung der Leistung läßt sich beim erfindungsgemäßen Verstärkersystem also durch zusätzliche, stromgesteuerte Endstufen erreichen. Die Steuerung dieser zusätzlichen Leistungsstufen erscheint als eine geringe Last für den Grundverstärker BAA, so daß seine Stabilität nicht gefährdet wird. So ist ein bestimmter Aufbau des Grundverstärkers für jedwede gewünschte Leistung möglich, ohne daß das gesamte Verstärkersystem vollständig umgestaltet werden muß. Selbstverständlich muß jede Erweiterungsstufe bedingungslos stabil sein, und das umso mehr, wenn mit dem Verstärkungsfaktor eins gearbeitet wird.

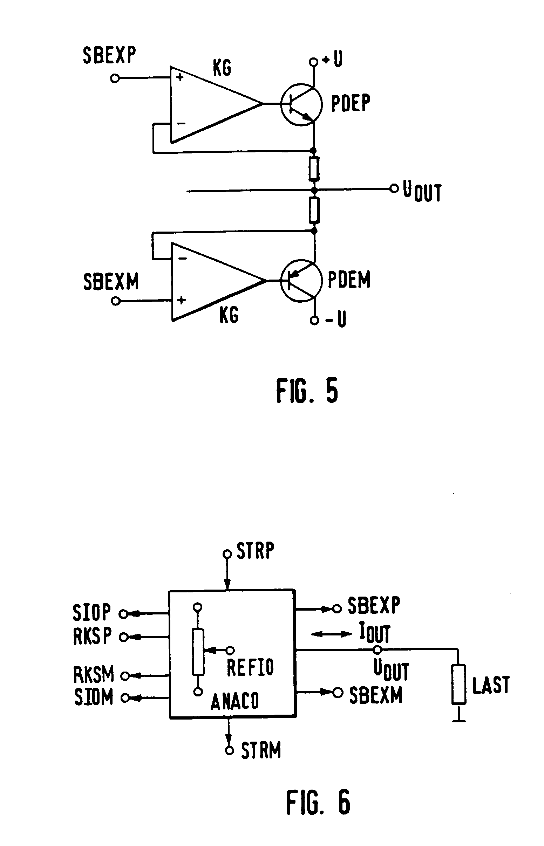

Gemäß Fig. 4 besteht jede Buserweiterungsstufe BEX aus zwei stromgesteuerten Leistungstransistoren, einer für die "Minus"-Seite und einer für die "Plus"-Seite. Es ist möglich, so viele Buserweiterungsstufen BEX an der aus dem Analogrechner herausgeführten Ausgangsleitung $U_{OUT}$ anzuschließen, weil die Steuerung durch Strom mittels eines angepaßten Analogbus SBEXP, SBEXM erfolgt. Die Grundzelle der Erweiterungsstufe ist detaillierter in Fig. 5 dargestellt. Hiernach sind die Bus-Erweiterungsstufen BEX mit der Funktion eines Spannungs-Strom-Wandlers versehene. Das Verhältnis Spannung/Strom kann geändert werden. Das bedeutet, daß eine Buserweiterungsstufe BEX mit einem anderen Strom als der Grundverstärker BAA arbeiten kann. Selbstverständlich können auch bei einer Mehrzahl einzelner Buserweiterungsstufen BEX diese mit unterschiedlichen Strömen betrieben werden. Mit anderen Worten, die Strom-werte, die von jeder einzelnen Buserweiterungsstufe behandelt werden, können sich unterscheiden, je nach benutztem Leistungstransistor PDEP, PDEM. Dies alles erhöht die Flexibilität des Verstärkersystems und ermöglicht den Austausch eines defekten Leistungstransistors durch einen anderen ohne viele Ein/Ausbau- und Kompatibilitäts-probleme.

Der Analogbus besteht aus zwei Signalleitungen, die jeweils aus dem Analogrechner ANACO herausgeführt sind und gemäß folgenden Gleichungen arbeiten :

$$SBEXP = STRP + I0$$

$$SBEXM = STRM + I0,$$

wobei STRP der Strom vom Leistungstransistor PDP des Grundverstärkers BAA (Plus-Seite) und STRM der Strom vom Leistungstransistor PDM des Grundverstärkers BAA (Minus-Seite) ist.

Unter Anpassung des Analogbusses versteht man die Gleichung zwischen der Ausgangsimpedanz eines Signalgenerators im Analogrechner ANACO, der charakteristischen Impedanz der Leitungen und einem am Ende der Leitungen eingebauten Widerstand. Zu bemerken ist, daß die Anpassung nicht unbedingt notwendig ist. Zu bemerken ist noch, daß es sich bei der Buserweiterung BEX nicht um eine einfache Parallelschaltung der Leistungstransistoren handelt; vielmehr kann jeder Leistungstransistor erfindungsgemäß einzeln und unabhängig gesteuert werden. Ein Paar komplementärer Leistungs-transistoren PDEP, PDEM bildet - gegebenenfalls mit vorgeschalteten Spannungs-Strom-Wandlern als Koppel-glieder - eine Erweiterungsbaugruppe, die nach Wunsch nachgerüstet werden kann.

Gemäß Fig. 4 und 6 generiert der Analogrechner ANACO die Rückkopplungssignale RKSP, RKSM für die einzelnen End-verstärkerzweige BAAP, BAAM des Grundverstärkers BAA sowie die Steuersignale SBXP, SBXM für die Leistungserweiterungstransistoren PDEP, PDEM der Buserweiterungsstufen BEXP bzw. BEXM. Der Analogrechner ANACO gibt dem Grundverstärkerteil BAA ein Rückkopplungssignal, der beispielsweise aus der Ausgangsspannung $U_{OUT}$ und einer Fehlspannung für den Ruhestrom I0 bestehen kann. Außerdem berechnet der Analogrechner ANACO den Leistungsverlust der Leistungs-transistoren und schützt im Fall einer Überschreitung maximaler Grenzwerte die Endleistungsstufe gegen Überlastung. Die Liste der Schnittstellensignale des Analogrechners ANACO mit dem Kleinsignal- bzw. Grundverstärkerteil BAA ist wie folgt:

STRP - Strom vom Leistungstransistor des Grundverstärkers BAA, Plus-Seite;

STRM - Strom vom Leistungstransistor des Grundverstärkers BAA, Minus-Seite;

SIOP - Steuersignal für Ruhestrom I0, Plus-Seite;

SIOM - Steuersignal für Ruhestrom I0, Minus-Seite;

RKSP - Rückkopplungssignal, Plus-Seite; und

RKSM - Rückkopplungssignal, Minus-Seite.

Die Schnittstellensignale mit den Buserweiterungsstufen BEX sind wie folgt:

SBEXP -  Steuersignal für BUS-Erweiterung, Plus-Seite;

SBEXM -  Steuersignal für BUS-Erweiterung, Minus-Seite.

Weitere wichtige Signale:

REFI0 -  Referenz für I0-Ruhestrom;
IOUT -   Ausgangsstrom;
UOUT -   Ausgangsspannung;
I0 -     Ruhestrom durch die Leistungstransistoren.

Mit diesen Abkürzungen kann man folgende Gleichungen für den Betrieb des erfindungsgemäßen Leistungsverstärker-systems aufstellen:

$$I0 = [STRP-(-STRM)] - Absolutwert (IOUT);$$

$$SIOP = SIOM = K \times (REFI0 - I0),$$

wobei K eine Konstante ist.

Im Rahmen der Erfindung liegen mehrere Arten der Rückkopplungen:

$$RKSP = UOUT + K \times STRP$$

$$RKSM = UOUT + K \times STRM.$$

Die Ruhestrom-Steuersignale SIOP und SIOM werden solchenfalls in einem anderen Punkt der Verstärkungskette des Grund- bzw. Kleinsignalverstärkers BAA mit dem Nutz-signal gemischt.
Findet die Signalmischung schon im Analogrechner statt, dann gilt:

$$RKSP = UOUT + SIOP$$

$$RKSM = UOUT + SIOM.$$

Andererseits kann im Rahmen der Erfindung Mischung auch bedeuten, daß das zu verstärkende Eingangangssignal in den "basic amplifiers plus/minus" (BAAM,BAAP) mit dem Ausgangsignal des Analogrechners ANACO algebraisch addiert wird.
Die Analogbus-Erweiterungssignale werden wie folgt betrieben:

$$SBEXP = A1 \times (STRP + I0)$$

$$SBEXM = A2 \times (STRM + I0),$$

wobei A1, A2 Konstante sind.
Die technische Realisierung all dieser Gleichungen mittels Rechenschaltungen innerhalb des Analogrechners ist dem Fachmann geläufig.
Die Liste weiterer, verwendeter Abkürzungen bzw. Bezugzeichen:

BAA -    Grund- bzw. Kleinsignalverstärker-Modul;
BAAP -   Grundverstärkerzweig für positive Spannung;
BAAM -   Grundverstärkerzweig für negative Spannung;
PDP -    Leistungstransistor des BAAP;
PDM -    Leistungstransistor des BAAM;
BEX -    Leistungserweiterungsbaugruppe;
BEXP -   Leistungserweiterungszweig für positive Spannung;
BEXM -   Leistungserweiterungszweig für negative Spannung;
PDEP -   Leistungserweiterungstransistor des BEXP;
PDEM -   Leistungserweiterungstransistor des BEXM;
SIOP -   Steuersignal für I0 Plus-Seite
SIOM -   Steuersignal für I0 Minus-Seite
STRP -   Strom Transistor Plus Seite
STRM -   Strom Transistor Minus Seite
SBEXP -  Steuersignal für BUS-Erweiterung, Plus-Seite;
SBEXM -  Steuersignal für BUS-Erweiterung, Minus-Seite;
I0 -     Ruhestrom durch die Leistungstransistoren;
ANACO -  Analogrechner;
REFI0 -  Referenzwert für I0.

Praktische Versuche mit erfindungsgemäß realisierten Verstärkern haben folgende Durchschnittsresultate ergeben :

1. Grundverstärker BAA ohne Buserweiterung BEX bei einer Gesamtverstärkung von 70 (37) dB (Vorverstärker mit A = 20 dB einbezogen):

Ausgangsspannung: +/- 60 Volt

Ruhestrom (vom Leistungstransistor): < 10 Milliampere

Durchgehende Leistung bei 1 KHz und 120 Watt (Effektivwert) an 15 Ohm

Bandbreite bei voller Leistung (- 3 dB):
DC - 1,2 MHz

Bandbreite (Verstärkung 1): > 7 MHz

Anstiegszeit: > 700 Volt / Mikro-Sek.

2. Grundverstärker BAA mit zwei Buserweiterungsstufen - Gesamtverstärkung = 70 (37 dB) (Vorverstärker mit A = 20 dB einbezogen):

Ausgangsspannung: +/- 80 Volt

Ruhestrom (Leistungstransistor): < 10 Milliampere

Durchgehende Leistung bei 1 KHz und 800 Watt (Effektivwert) an 4 Ohm

Bandbreite bei voller Leistung (- 3 dB):
DC - 1 MHz

Bandbreite (Verstärkung 1): 7 MHz

Anstiegszeit: > 700 Volt / Mikro-Sek.

"Fehlerspannung für den Ruhestrom" ist eine Ausgangsspannung des Analogrechners ANACO und stellt eine Verstärkung der Differenz zwischen dem tatsächlichen, momentanen Ruhestrom I0 und dem vorgegebenen Referenz-Ruhestrom REFI0 dar. Durch die interne, große Verstärkung ist diese Eingangsfehlerspannung des Analogrechners verschwindend klein, aber nicht zu vernachlässigen. Diese durch den Analogrechner verstärkte Fehlerspannung wird mit dem Eingangssignal addiert und steuert zusammen mit diesem die Endstufe. Dies führt zu dem Ergebnis, daß man am Ausgang das verstärkte Signal findet (z.B. zehnfach), jedoch müssen die Endstufen der Plus- und Minus-Seite gleichzeitig den Ruhestrom durchlassen.

Außer der Regelung des Ruhestroms kann der Analogrechner im Rahmen der Erfindung auch die Leistungstransistoren schützen. Alle heute existierenden Leistungshalbleiter oder Röhren haben eine eigene maximale Verlustleistung. Diese wird in Wärme umgesetzt. Wenn diese Wärme nicht abgeleitet werden kann, wird der Leistungstransistor / die Röhre nach einiger Zeit zerstört. Die Daten aus Bauelemente-Katalogen schreiben auch einen maximalen Strom und eine maximale Spannung vor, die nicht überschritten werden darf. Andernfalls würden die Leistungstransistoren / Röhren zerstört. Der Analogrechner rechnet die momentane Verlustleistung an jedem Transistor / jeder Röhre und hält die momentane Verlustleistung je nach Sicherheits-anforderungen knapp unter dem Maximalwert, um die Wärmeableitung zu gewährleisten oder läßt kurzzeitig einen höheren Strom zu, der die Verlustleistung für einen Bruchteil von Sekunden über den Maximalwert treibt. Der Analogrechner vergleicht die am Transistor / an der Röhre momentan anliegende Spannung und den Strom mit den zulässigen Maximalwerten, und im Fall der Überschreitung der Sicherheitswerte trifft er entsprechende Maßnahmen.

Durch die Eingangssignalfrequenzerhöhung wächst der Ruhestrom aufgrund natürlicher, pysikalischer Erscheinungen. Der Analogrechner sensiert, durch Vergleich des momentanen Ruhestroms mit dessen Sollwert, die Erhöhung und blockiert entsprechend die Leistungs-transistoren / Röhren. Das ist eigentlich äquivalent mit der Änderung des statischen Arbeitspunkts, abhängig von der Frequenz.

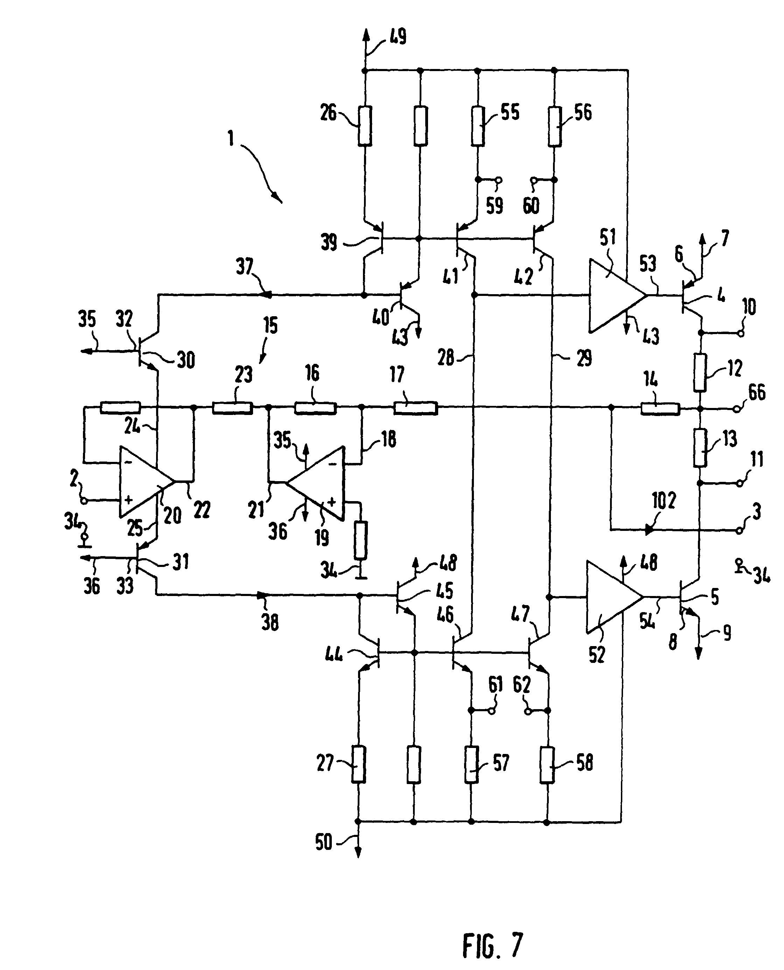

Fig. 7 enthält einen auf die wesentlichen Elemente reduzierten Schaltplan eines Leistungsverstärkers 1. Die Eingangsklemme ist mit 2, der Ausgangsanschluß mit 3 bezeichnet. Die Ausgangsstufe ist aus zwei zueinander komplementären Leistungstransistoren 4,5 gebildet. Der eine Leistungstransistor 4 ist ein pnp-Typ, dessen Emitteranschluß 6 mit der positiven Versorgungsspannung 7 verbunden ist. Diesem gegenüber ist der andere Leistungstransistor 5 ein npn-Typ, dessen Emitteranschluß 8 mit der negativen Versorgungsspannung 9 verbunden ist. Die Kollektoranschlüsse 10,11 dieser beiden Transistoren 4,5 sind über zwei niederohmige Meßwiderstände 12,13 miteinander verbunden. Zwischen dem gemeinsamen Knoten 66 dieser beiden Meßwiderstände 12,13 und der Ausgangsklemme 3 des Leistungsverstärkers 1 ist ein weiterer niederohmiger Meßwiderstand 14 eingeschalten.

Die Spannung an der Ausgangsklemme 3 des Leistungsverstärkers 1 wird durch einen übergeordneten Spannungsregler 15 mit dem Eingangssignal an der Klemme 2 verglichen und so ausgeregelt, daß eine Proportionalität zwischen Eingangs- und Ausgangssignal 2,3 gewährleistet ist. Zu diesem Zweck wird das Ausgangssignal 3 durch einen als Inverter beschalteten Operationsverstärker 19 im Verhältnis der Widerstände 16,17, welches dem umgekehrten Verhältnis der gewünschten Verstärkung entspricht, heruntergeteilt und niederohmig zur Verfügung gestellt. Gleichermaßen wird mit dem Eingangssignal 2 verfahren, das durch den als Spannungsfolger beschalteten Operationsverstärker 20 mit unveränderter Spannung, jedoch erhöhtem Ausgangsstrom bereitgestellt wird. Die beiden Ausgänge 21,22 sind durch einen relativ hochohmigen Widerstand 23 miteinander verbunden, der die betreffende Spannungsdifferenz in ein dazu proportionales Stromsignal umwandelt. Dieser Strom ist je nach Polarität näherungsweise gleich der Stromaufnahme des Operationsverstärkers 20 an dessen positivem Betriebsspannungsanschluß 24 oder am negativen Betriebsspannungsanschluß 25. Diese Ströme fließen durch die Eingangswiderstände 26,27 der Ansteuerstufen 28,29 und erzeugen dort einen auf die jeweilige Betriebsspannung 7,9 bezogenen, zur Spannungsdifferenz an dem Widerstand 23 proportionalen Spannungsabfall.

Um die Betriebsspannungseingänge 24,25 des Operationsverstärkers 20 vor Überspannungen zu schützen, ist zwischen den Betriebsspannungsanschlüssen 24,25 und den Eingangswiderständen 26,27 der Ansteuerstufen 28,29 je ein Transistor 30, 31 eingeschaltet. Die Basisanschlüsse 32,33 dieser Transistoren 30, 31 liegen auf gegenüber der Schaltungsmasse 34 konstant gehaltenen positiven und negativen Versorgungsspannungen 35, 36 mit für den Operationsverstärker 20 ungefährlichen Werten. Diese Versorgungsspannungen 35,36 übertragen sich über die als Emitterfolger beschalteten Transistoren 30,31 auf die Betriebsspannungseingänge 24,25 des Operationsverstärkers 20.

Die Ströme 37,38, welcher der Operationsverstärker 20 an seinen Betriebsspannungseingängen 24,25 zieht, um an seinem Ausgang 22 einen betreffenden Ausgangsstrom liefern zu können, durchfließen primär die Eingangswiderstände 26,27 der Ansteuerstufen 28, 29. Die Transistoren 39 und 40 bilden zusammen mit den Transistoren 41 und 42 je einen Stromspiegel, der dafür sorgt, daß die Emitterströme der Transistoren 41 und 42 näherungsweise proportional zum Strom 37 sind. Zu diesem Zweck ist der Kollektor des Transistors 40 an eine feste Versorgungsspannung 43 gelegt, welche um einige Volt niedriger ist als die positive Versorgungsspannung 7. Eine ähnliche Funktion haben die Transistoren 44 und 45, welche ebenfalls zusammen mit den Transistoren 46 und 47 je einen Stromspiegel bilden und dafür sorgen, daß die Emitterströme der Transistoren 46 und 47 näherungsweise proportional zum Strom 38 sind. Der Kollektor des Transistors 45 ist mit einer konstanten Versorgungsspannung 48 verbunden, welche um einige Volt höher ist als die negative Versorgungsspannung 9.

Je zwei Transistoren 41 und 46 bzw. 42 und 47 sind zur Bildung je einer Ansteuerstufe 28,29 in Reihe geschaltet. Da der Strom durch den Widerstand 23 gleichzeitig nur in eine Richtung fließen kann, nimmt der Operationsverstärker 20 jeweils nur an einem seiner beiden Betriebsspannungseingänge 24, 25 einen nennenswerten Strom 37,38 auf, so daß die Transistoren 41, 46 sowie 42,47 im Gegentakt angesteuert werden. Andererseits ist aber der Strom an dem zweiten Betriebsspannungseingang 25,24 des Operationsverstärkers 20 aufgrund des internen Stromverbrauchs niemals null, so daß wegen der Stromspiegel 39,40,41,42 bzw. 44,45,46,47 keiner der Ausgangstransistoren 41,42,46,47 der beiden Ansteuerstufen 28,29 jemals vollständig gesperrt ist. Aus diesem Grund kann ein ständiger Ruhestrom durch die Ausgangstransistoren 41,46 sowie 42, 47 der Ansteuerstufen 28, 29 fließen, so daß sich die Potentiale 28,29 nahezu über den gesamten Bereich zwischen den Versorgungsspannungen 49 und 50 einstellen können. Die Ausgangssignale der Ansteuerstufen 28,29 werden von je einem Treiberbaustein 51,52 niederohmig an der Basis 53,54 je eines der beiden Leistungstransistoren 4,5 zur Verfügung gestellt.

In den Emitterkreis der Ausgangstransistoren 41,42,46,47 der beiden Ansteuerstufen 28,29 ist je ein Emitterwiderstand 55,56,57,58 geschaltet. Durch Parallelschaltung weiterer Transistoren können an den Emitteranschlüssen 59,60,61 und 62 der Ausgangstransistoren 41,42,46,67 der Ansteuerstufen 28,29 zusätzliche Ströme eingespeist werden, welche die betreffenden Emitterwiderstände 55,56,57,58 durchfließen, hierdurch die Gegenkopplung des betreffeden Stromspiegels beeinflussen und somit eine Veränderung des Ausgangssignals der betreffenden Ansteuerstufen 28,29 hervorrufen.

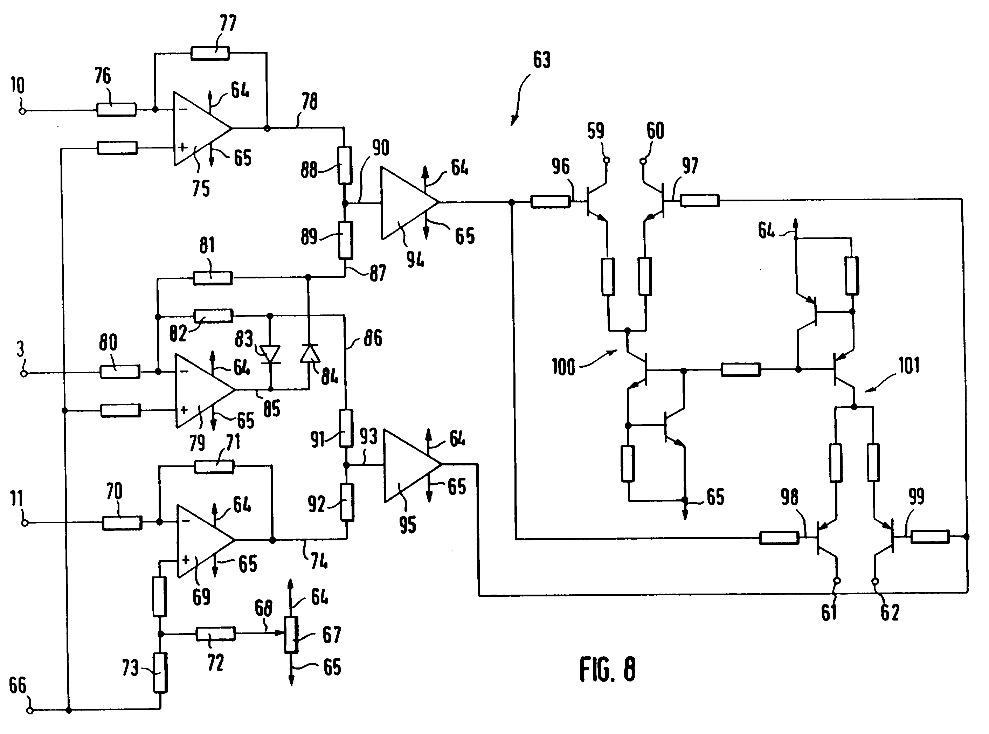

Der Ruhestrom durch die Leistungstransistoren 4,5 des Leistungsverstärkers 1 wird durch den in Figur 8 wiedergegebenen Ruhestromregler 63 auf einen konstanten Wert geregelt. Die Eingangssignale des Ruhestromreglers 63 sind das Potential des Sternpunkts 66 der Meßwiderstände 12,13,14 sowie die Signale an deren freien Enden 3,10,11. Das Potential des Sternpunkts 66 bildet gleichzeitig das Bezugspotential für den Ruhestromregler 63. Da es näherungsweise dem Ausgangssignal 3 folgt, welches einen Spannungshub zwischen den beiden Versorgungsspannungen 7,9 ausführt, ist für den Ruhestromregler 63 eine eigene, dieser Potentialschwankung folgende Stromversorgung notwendig. Diese besteht aus einer gegenüber dem Bezugspotential konstanten positiven Betriebsspannung 64 und einer gegenüber dem schwankenden Bezugspotential 66 ebenfalls konstanten, negativen Versorgungsspannung 65.

Im Folgenden sollen zur Vereinfachung des Ausdrucks die Signale des Ruhstromreglers 63 auf das Potential 66 bezogen werden, ohne dies ausdrücklich zu erwähnen. Eine negative Spannung soll demnach negativ gegenüber dem Bezugspotential 14 sein, obwohl sie in Wirklichkeit, bezogen auf das Massepotential 34 des Leistungsverstärkers, positiv sein kann.

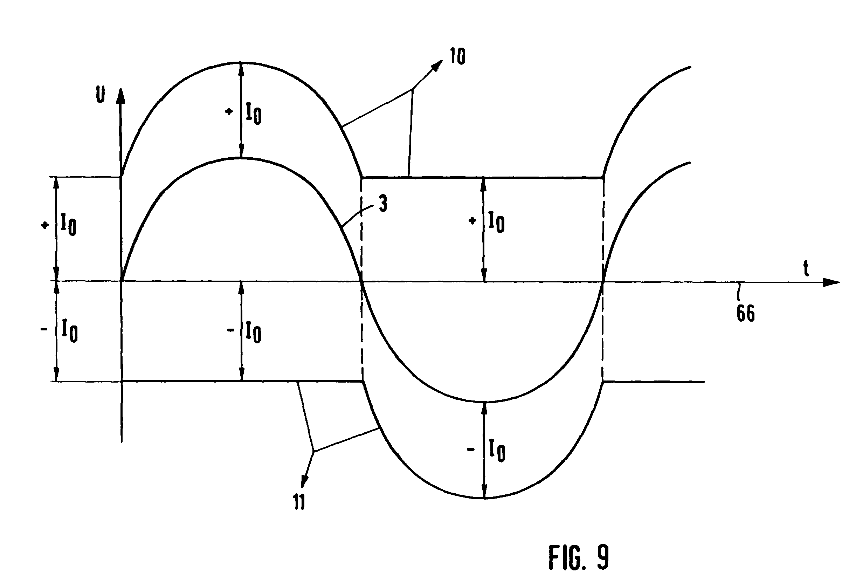

Beispielhafte Verläufe der Spannungen 3,10 und 11 sind in Figur 9 dargestellt. Aus diesen Eingangsspannungen bildet der Ruhestromregler Ausgangsströme an den Klemmen 59,60,61,62, die an den betreffenden Punkten des Leistungsverstärkers 1 eingekoppelt werden und eine wirkungsvolle und präzise Regelung des Ruhestroms ermöglichen, ohne den übergeordneten Spannungsregler 15 zu beeinflussen.

An dem Potentiometer 67 ist der Ruhestromsollwert vorgegeben. Von diesem an dem Abgriff 68 des Potentiometers 67 eingestellten Spannungspotential wird vermittels des als Subtrahierer beschalteten Operationsverstärkers 69 die Eingangsspannung 11 subtrahiert. Zu diesem Zweck sind die Widerstände 70,71,72,73 gleich groß gewählt. Am Ausgang 74 des Operationsverstärkers 69 stellt sich daher eine Spannung ein, welche gleich der Differenz der Spannung 68 minus der Spannung 11 ist.

Der Operationsverstärker 75 ist als einfacher Inverter beschaltet, die Widerstände 76 und 77 sind gleich groß, so daß das Ausgangssignal 78 des Operationsverstärkers 75 gleich der invertierten Eingangsspannung 10 ist.

Auch der Operationsverstärker 79 ist im Prinzip als Inverter beschalten, bei dem die Widerstände 80,81,82 identisch sind. Jedoch ist die Rückkopplung über die beiden Widerstände 81,82 durch zwei zusätzliche, antiparallele Dioden 83 und 84 je nach Polarität der Eingangsspannung 3 des Ruhestromreglers 63 unterschiedlich. Bei positiver Eingangsspannung 3 fließt ein Strom über die Widerstände 80,82 und die Diode 83 zum Ausgang 85 des Operationsverstärkers 79, während bei negativer Eingangsspannung 3 ein Strom vom Ausgang 85 des Operationsverstärkers 79 über die Diode 84 und die Widerstände 81,80 zur Eingangsklemme 3 fließt. Dies hat zur Folge, daß bei positiver Eingangsspannung 3 am Knoten 86 die invertierte Eingangsspannung 3 abgegriffen werden kann, während gleichzeitig am Knoten 87 näherungsweise die Spannung null anliegt. Umgekehrt ist bei negativer Eingangsspannung 3 das Potential am Knoten 87 gleich dieser invertierten Einganssspannung 3, während am Knoten 86 näherungsweise Nullpotential vorliegt.

Durch die gleich groß dimensionierten Widerstände 88 und 89 wird der Mittelwert 90 zwischen den beiden Potentialen 78 und 87 gebildet. Ähnlich dienen die identischen Widerstände 91 und 92 dazu, den Mittelwert 93 zwischen den Spannungspotentialen 74 und 86 zu bilden. Die Signale 90 und 93 werden vermittels Treiberbausteinen 94,95 an die zueinander komplementären Eingänge 96,97 bzw. 98,99 zweier Differenzverstärker 100, 101 gelegt.

Die Operationsverstärker 69,75 und 79 sind so geschaltet, daß die Differenz zwischen den Spannungspotentialen 90 und 93 zu jedem Zeitpunkt gleich der Differenz von Ruhestromsoll- und -istwert ist. Bspw. wird während der positiven Halbwelle der Reglereingangsspannung 3 der Ausgangsstrom 102 des Leistungsverstärkers 1 von dem oberen Leistungstransistor 4 geführt, der zusätzlich dazu von dem Ruhestrom durchflossen wird. In diesem Moment wird die Diode 83 leitend und das invertierte Reglereingangssignal 3 über den Knoten 86 dem Signal 93 zugeschlagen, das an den Eingängen 97 und 99 der Differenzverstärker 100, 101 angelegt ist. Der Anteil des Eingangssignals 10, welches dem Ausgangsstrom 102 entspricht, wird in dem Operationsverstärker 75 ebenfalls invertiert und dem Signal 90 zugeschlagen, welches an die jeqweils anderen Eingänge 96,98 der Differenzverstärker 100, 101 angelegt ist. Diese beiden Spannungsanteile führen zu einer gleichsinnigen Verstellung der Eingangssignale 96,97,98,99 der Differenzverstärker 100, 101, welche sich auf deren Ausgangsströme an den Klemmen 59,60,61,62 nicht auswirken.

Die übrigen Anteile der Eingangsspannungen 10 und 11, welche den konstanten Ruheströmen entsprechen, werden ebenfalls beide invertiert und ebenfalls den an unterschiedliche Eingänge 96,97 bzw. 98,99 der Differenzverstärker 100,101 gelegten Spannungen 90, 93 zugeschlagen. Da die Eingangsspannungen 10,11 aufgrund der Dreieckschaltung der Meßwiderstände 12,13 und 14 entgegengesetze Polarität aufweisen, werden die Signale 90,93 jedoch entgegengesetzt verstellt, so daß an den Differenzverstärkerausgängen 59 und 60 bzw. 61 und 62 ebenfalls eine gegensinnige Aussteuerung auftritt.

Da schließlich in dem Operationsverstärker 69 der Ruhestromsollwert 67 subtaktiv berücksichtigt worden ist, folgt, daß die Differenz der Eingangssignale 96 und 97 bzw. 98 und 99 der Differenzverstärker 100 und 101 proportional zur Abweichung des Ruhstromist- vom Ruhestromsollwert ist. Diese Regeldifferenz wird durch die Differenzverstärker 100 und 101 verstärkt und als Stromdifferenz an den Emitteranschlüssen 59,60 bzw. 61,62 der Ausgangstransistoren 41, 42,46,47 der Ansteuerstufen 28,29 eingekoppelt. In den Emitterwiderständen 55,56 bzw. 57,58 findet eine Addition dieser Stromdifferenz mit den Emitterströmen der Transistoren 41,42,46,47 statt, welche näherungsweise gleich den Ausgangsströmen 37,38 des Spannungsreglers 15 sind. Da bei einer Abweichung vom vorgegebenen Ruhestromsollwert die eingekoppelten Ströme an den Anschlüssen 59 und 60 bzw. 61 und 62 gegensinnig verstellt werden, erfolgt eine Pegelverschiebung zwischen den Ausgangssignalen 28,29 der Ansteuerstufen, wodurch insbesondere der vom Ausgangsstrom 102 nicht durchflossene Leistungstransistor 4 oder 5 weiter geöffnet oder gesperrt wird, so daß der Ruhestrom durch die beiden Leistungstransistoren 4,5 gleich dem an dem Potentiometer 67 eingestellten Sollwert und damit konstant bleibt.

**Patentansprüche**

1. Elektrischer Leistungsverstärker (1), mit mehreren LeistungsVerstärkerelementen (PDP, PDM; PDEP, PDEM), insbesondere Leistungs-transistoren (4, 5), die ausgangsseitig zueinander paarweise komplementär in Gegentakt-B-Betriebsschaltung angeordnet sind, und die eingangsseitig (53, 54) an je eine von dem Eingangssignal (2) des Verstärkers (1) beeinflußte Ansteuerspannung (28, 29) angeschlossen sind, sowie mit einer oder mehreren Vorspannungsquellen (BAAP, PREAMP, BAAP, BAAM; Spannung zwischen Knoten 59 und 60 bzw. 61 und 62), die ständig zwischen das Eingangssignal (2) des Verstärkers (1) und die Ansteuerspannung (28, 29) mindestens eines Leistungs-Verstärkerelements (PDP, PDM; PDEP, PDEM; 4, 5) gekoppelt ist (sind), um einen möglichst konstanten, durch die Leistungs-Verstärkerelemente (PDP, PDM; 4, 5) fließenden Querstrom ($I_0$) zu erzeugen, **gekennzeichnet** durch Meßwertaufnehmer (12, 13, 14) zur Erfassung der durch die Leistungs-Verstärkerelemente (PDP, PDM; 4, 5) fließenden Ströme (STRP, STRM, $I_0$), deren Signalausgänge in Stern geschalten sind, so daß die durch die Leistungs-Verstärkerelemente (PDP, PDM; 4, 5) fließenden Ströme (STRP, STRM, $I_0$) und der Ausgangsstrom ($I_{OUT}$;

102) einzeln als Rechenvariable einem Regler (ANACO; 63) zugeführt sind, der daraus nach vorgegebenen Rechenvorschriften Steuersignale (RKSP, RKSM; STRP, STRM) für die Vorspannungsquelle(n) (BAAP, BAAM; 59-62) generiert, so daß je nach Abweichung des rückgekoppelten Querstroms ($I_0$) von einem Sollwert sowie ggf. zusätzlich abhängig von der Signalfrequenz die Arbeitspunkte der Leistungs-Verstärkerelemente (PDP, PDM; 4, 5) so verstellt werden, daß die Abweichung minimiert wird, wobei das Bezugspotential (66) des Querstromreglers (63) gleich dem Potential des Sternpunkts der Meßwertaufnehmer (12, 13, 14) ist.

2. Leistungsverstärker nach Anspruch 1, dadurch gekennzeichnet, daß die Vorspannungsquelle (BAAP, BAAM) im Rahmen eines vom Regler (ANACO) angesteuerten, vorzugsweise mehrstufigen Kleinsignalverstärkers ausgeführt und/oder mit diesem baulich integriert ist.

3. Leistungsverstärker nach Anspruch 1 oder 2, gekennzeichnet durch zwei vom Regler (ANACO) angesteuerte Kleinsignalverstärker (BAAP, BAAM), die je einem der paarweise komplementären Leistungsverstärkerelemente (PDP,PDM) zugeordnet sind und gegebenenfalls jeweils eine Rückkopplung vom Leistungsverstärkerelement (PDP, PDM) aufweisen.

4. Leistungsverstärker nach Anspruch 2 oder 3, dadurch gekennzeichnet, daß dem oder den Kleinsignalverstärkern (BAAP, BAAM) ein gegebenenfalls gemeinsamer Vorverstärker (PREAMP) vorgeschaltet ist.

5. Leistungsverstärker nach einem der vorangehenden Ansprüche, dadurch gekennzeichnet, daß der Regler (ANACO) zwischen den paarweise komplementären Leistungsverstärkerelementen (PDP, PDM) angekoppelt ist, insbesondere den in Serie liegenden Emitter-Kollektorstrecken der Leistungstransistoren, zwischengeschaltet ist und einen Leistungssignal-Ausgang ($U_{OUT}$) zum Herausführen des Leistungsverstärker-Ausgangssignals aufweist.

6. Leistungsverstärker nach Anspruch 5, dadurch gekennzeichnet, daß am Leistungssignalausgang ($U_{OUT}$) ein oder mehrere weitere Leistungsverstärkerelemente (BEXP, BEXM) und/oder Leistungsverstärkerelementepaare (PDEP, PDEM), jeweils eine separate Erweiterungsstufe (BEX) in Gegentakt-B-Betriebsschaltung bildend, parallel angeschaltet sind, wobei jedes Leistungsverstärkerelement (BEXP, BEXM, PDEP, PDEM) vom Regler (ANACO) angesteuert ist.

7. Leistungsverstärker nach Anspruch 6, dadurch gekennzeichnet, daß die Erweiterungsstufe (BEX) ein zwischen dem Leistungsverstärkerelement (PDEP, PDEM) und dem Regler (ANACO) angeordnetes Koppelglied (KG) aufweist, das als Impedanzwandler und/oder vom Regler (ANACO) kontrolliertes, aktives Steuerelement realisiert ist.

8. Leistungsverstärker nach Anspruch 7, dadurch gekennzeichnet, daß das Koppelglied (KG) als Spannungs-Strom-Wandler mit Rückkopplung der durch das Leistungsverstärkerelement (PDEP, PDEM) fließenden Ströme (SBEXP, SBEXM) ausgeführt ist.

9. Leistungsverstärker nach einem der Ansprüche 6 bis 8, gekennzeichnet durch einen von dem Regler (ANACO) kontrollierten Analogbus (SBEXP, SBEXM), von dem aus eine oder mehrere Erweiterungsstufen (BEX) parallel steuerbar sind, wobei der Analogbus (SBEXP, SBEXM) zwei aus dem Regler herausgeführte Signalausgangsleitungen aufweist, an die jeweils die Leistungs-Verstärkerelemente (PDEP; PDEM) positiver oder negativer Betriebsspannung zu ihrer Steuerung angekoppelt sind.

10. Leistungsverstärker nach Anspruch 9, dadurch gekennzeichnet, daß der Analogbus (SBEXP, SBEXM) entsprechend der Regler-Ausgangsimpedanz, der charakteristischen Impedanz seiner Leitungen und einem am Ende der Busleitung eingebauten Abschlußwiderstand angepaßt ist.

11. Leistungsverstärker nach Anspruch 9 oder 10, dadurch gekennzeichnet, daß die beiden, aus dem Analogrechner (ANACO) herausgeführten Signalausgangsleitungen gemäß folgenden Gleichungen arbeiten:

$$SBEXP = STRP + I0,$$

$$SBEXM = STRM + I0,$$

wobei STRP der Strom vom Leistungstransistor PDP des Grundverstärkers BAA (Plus-Seite) und STRM der Strom vom Leistungstransistor PDM des Grundverstärkers BAA (Minus-Seite) ist.

12. Leistungsverstärker nach einem der vorangehenden Ansprüche, dadurch gekennzeichnet, daß der Regler (ANACO) mehrere, zueinander komplementäre Steuerausgänge (RKSP, RKSM; STRP, STRM; SBEXP, SBEXM) aufweist, die jeweils einem Leistungs-Verstärkerelement (PDP, PDM; PDEP, PDEM) entweder positiver oder negativer Polarität zugeordnet sind.

13. Leistungsverstärker nach einem der vorangehenden Ansprüche, dadurch gekennzeichnet, daß der Regler (ANACO) einen Analogrechner umfaßt.

14. Leistungsverstärker nach einem der vorangehenden Ansprüche, gekennzeichnet durch eine im Regler (ANACO), gegebenenfalls Analogrechner, integrierte Referenz-Spannungs- oder Stromquelle (REFIO) und ein Verknüpfungs-, insbesondere Vergleichselement, das an die Referenz-Quelle (REFIO) und an den durch die Leistungsverstärkerelemente fließenden (Quer-)Strom ($I_0$) angeschlossen ist.

15. Leistungsverstärker nach Anspruch 14, dadurch gekennzeichnet, daß der Regler als Analogrechner (ANACO) ausgeführt ist, der zur Erzeugung von Querstrom-Steuersignalen (SIOP, SIOM) ein Vergleichs- oder Summierglied für den Leistungsverstärkerelemente-Querstrom ($I_0$) und den Referenzstrom (REFIO) und ein nachgeschaltetes Multiplizierglied, das mit einem konstanten Pegel (K) verknüpft ist, aufweist.

16. Leistungsverstärker nach Anspruch 15, dadurch gekennzeichnet, daß das Querstrom-Steuersignal (SIOP, SIOM) einer mit einem Verstärker-Nutzsignal verknüpften Mischstufe zugeführt ist, die gegebenenfalls im Kleinsignalverstärker (BAA, BAAP, BAAM) enthalten ist.

17. Leistungsverstärker nach einem der vorangehenden Ansprüche, dadurch gekennzeichnet, daß der Regler als Analogrechner (ANACO) ausgeführt ist, der zur Erzeugung von Rückkopplungssignalen (RKSP, RKSM) ein mit einem konstantem Pegel (K) gekoppeltes Multiplizierglied für den durch ein Leistungsverstärkerelement fließenden Strom (STRP, STRM) und ein nachgeschaltetes Summierglied für das Leistungsverstärker-Ausgangssignal ($U_{OUT}$) aufweist.

18. Leistungsverstärker nach einem der Ansprüche 1 bis 16, dadurch gekennzeichnet, daß der Regler als Analogrechner (ANACO) ausgeführt ist, der eine Verknüpfungseinrichtung aufweist, die zur Erzeugung von Rückkopplungssignalen (RKSP, RKSM) ausgelegt ist, die abhängig vom Leistungsverstärker-Ausgangssignal ($U_{OUT}$, $I_{OUT}$) und/oder der Querstrom-Sollwert-Abweichung beziehungsweise einer entsprechenden Fehlerspannung generiert sind.

19. Leistungsverstärker nach Anspruch 15 und einem der sonstigen Ansprüche, dadurch gekennzeichnet, daß der Regler als Analogrechner (ANACO) ausgeführt ist, der zur Erzeugung von Rückkopplungssignalen (RKSP, RKSM) ein Summierglied aufweist, das mit dem Leistungsverstärker-Ausgangssignal ($I_{OUT}$, $U_{OUT}$) und dem Querstrom-Steuersignal (SIOP, SIOM) verbunden ist.

20. Leistungsverstärker nach Anspruch 2, 3 oder 4 und einem der Ansprüche 17, 18 oder 19, dadurch gekennzeichnet, daß das Rückkopplungssignal (RKSP, RKSM) dem Kleinsignalverstärker (BAA, BAAP, BAAM) zugeführt ist.

21. Leistungsverstärker nach Anspruch 10, dadurch gekennzeichnet, daß der Regler als Analogrechner (ANACO) ausgeführt ist, der zur Erzeugung von Analogbus-Ausgangssignalen (SBEXP, SBEXM) mit einem Summierglied für den Leistungsverstärkerelemente-Querstrom (10) und den durch ein Leistungsverstärkerelement fließenden Strom (STRP, STRM) und gegebenenfalls einem nachgeschalteten Multiplizierglied versehen ist, das mit einem konstantem Pegel (Al, A2) gekoppelt ist.

22. Leistungsverstärker nach einem der vorangehenden Ansprüche, dadurch gekennzeichnet, daß der Regler als Analogrechner (ANACO) ausgeführt ist, der eine Rechenschaltung für den Leistungsverlust der Leistungs-Verstärkerelemente (PDP, PDM; PDEP, PDEM) aufweist, die eine Einrichtung zum Schutz vor Überlastung der Leistungs-Verstärkerelemente ansteuert.

23. Elektrischer Leistungsverstärker (1) nach einem der vorhergenden Ansprüche, dadurch gekennzeichnet, daß die Meßwertaufnehmer in den jeweiligen Stromkreis eingeschaltete, ohmsche Widerstände (12, 13, 14) sind.

24. Leistungsverstärker nach Anspruch 23, dadurch gekennzeichnet, daß die freien Anschlüsse der Meßwiderstände (12, 13, 14) mit den Ausgängen (10, 11) der Leistungsverstärkerelemente (4, 5) einerseits sowie mit dem Ausgang (3) des Leistungsverstärkers (1) andererseits verbunden sind.

25. Leistungsverstärker nach Anspruch 24, gekennzeichnet durch gegenüber dem als Bezugspotential (66) dienenden Potential des Sternpunkts der Meßwertaufnehmer (12, 13, 14) konstante Versorgungsspannungen (64, 65) für den Querstromregler (63).

26. Leistungsverstärker nach einem der vorhergehenden Ansprüche, gekennzeichnet durch eine Analogschaltung (67 - 93) innerhalb des Querstromreglers (63), die aus den Meßsignalen (10, 11,3) für die durch die Leistungsverstärkerelemente (4, 5) fließenden Ströme sowie des Ausgangsstroms (102) des Leistungsverstärkers (1) ein zum Querstrom proportionales Rechensignal bildet.

**27.** Leistungsverstärker nach Anspruch 26, gekennzeichnet durch eine Subtraktionsschaltung (69 - 73) zur Bildung der Differenz zwischen dem zum Querstrom proportionalen Rechensignal und einem konstanten Querstrom-Sollwert (68).

**28.** Leistungsverstärker nach Anspruch 27, dadurch gekennzeichnet, daß zur Bildung des Reglerausgangssignals das zur Differenz zwischen Querstromsoll- und -istwert proportionale Rechensignal (90, 93) mit einem Faktor multipliziert, insbesondere verstärkt wird.

**29.** Leistungsverstärker nach Anspruch 28, dadurch gekennzeichnet, daß das Ausgangssignal (59 - 62) des Querstromreglers (63) zur Bildung des Ansteuersignals für eines der Leistungsverstärkerelemente (4, 5) dem gegebenenfalls vorverstärkten Verstärkereingangssignal oder dem Ausgangssignal (37, 38) eines übergeordneten Spannungsreglers (15) additiv oder subtraktiv überlagert wird.

**30.** Leistungsverstärker nach Anspruch 29, dadurch gekennzeichnet, daß das Ausgangssignal (59 - 62) des Querstromreglers (63) zur Bildung des Ansteuersignals für das andere Leistungsverstärkerelement (5; 4) dem gegebenenfalls vorverstärkten Eingangssignal oder dem Ausgangssignal (37, 38) eines übergeordneten Spannungsreglers (15) mit umgekehrter Polarität überlagert wird.

**31.** Leistungsverstärker nach Anspruch 29 oder 30, gekennzeichnet durch getrennte Ansteuerstufen (28, 29) für die beiden Leistungsverstärkerelemente (4, 5).

**32.** Leistungsverstärker nach Anspruch 31, dadurch gekennzeichnet, daß der oder die Ausgangstransistoren (41, 42, 46, 47) der mit dem Ausgangssignal (59 - 62) des Querstromreglers (63) gekoppelten Ansteuerstufe(n) (28, 29) in Emitterschaltung betrieben sind und die Überlagerung von Verstärkereingangs- und Querstromreglerausgangssignal (59 - 62) durch Stromgegenkopplung vermittels eines in den Emitterkreis dieses Transistors (41, 42, 46, 47) geschalteten Emitterwiderstands (55, 56, 57, 58) erfolgt, der zusätzlich zum Emitterstrom des Ansteuertransistors (41, 42, 46, 47) einen zum Ausgangssignal (59 - 62) des Querstromreglers (63) proportionalen Regelstrom führt.

**33.** Leistungsverstärker nach Anspruch 32, dadurch gekennzeichnet, daß das zur Differenz zwischen Querstromsoll- (68) und -istwert proportionale Rechensignal (90, 93) in einem Differenzverstärker (100, 101) verstärkt wird, von dessen Kollektorwiderständen einer identisch mit dem der Stromgegenkopplung dienenden Emitterwiderstand (55, 56, 57, 58) der Ansteuerstufe ist.

**34.** Leistungsverstärker nach Anspruch 33, dadurch gekennzeichnet, daß jede Ansteuerstufe (28, 29) aus zwei komplementären, in Emitterschaltung angeordneten sowie im Gegentakt betriebenen Transistoren (41, 46; 42, 47) mit je einem Emitterwiderstand (55, 57; 56, 58) gebildet ist, wobei diese Emitterwiderstände (55, 57; 56, 58) identisch mit den Kollektorwiderständen je eines Zweigs (59, 61; 60, 62) von zwei symmetrisch zum Bezugspotential (66) des Querstromreglers (63) angeordneten Differenzverstärkern (100, 101) sind.

**35.** Verfahren zum Betrieb eines elektrischen Leistungsverstärkers (1), insbesondere nach einem der vorangehenden Ansprüche, der mehrere Leistungs-Verstärkerelemente (PDP, PDM; PDEP, PDEM), insbesondere Leistungstransistoren (4, 5), aufweist, die ausgangsseitig zueinander paarweise komplementär in Gegentakt-B-Betriebsschaltung angeordnet sind, und die eingangsseitig (53, 54) an je eine von dem Eingangssignal (2) des Verstärkers (1) beeinflußte Ansteuerspannung (28, 29) angeschlossen sind, sowie eine oder mehrere Vorspannungsquellen (BAA, BAAP, BAAM; Spannung zwischen Knoten 59 und 60 bzw. 61 und 62), die ständig zwischen das Eingangssignal (2) des Verstärkers (1) und die Ansteuerspannung (28, 29) mindestens eines Leistungs-Verstärkerelements (PDP, PDM; 4, 5) gekoppelt ist (sind), um einen möglichst konstanten, durch die Leistungs-Verstärkerelemente (PDP, PDM; 4, 5) fließenden Querstrom ($I_0$) zu erzeugen, **dadurch gekennzeichnet**, daß die durch die Leistungs-Verstärkerelemente (PDP, PDM; 4, 5) fließenden Ströme (STRP, STRM, $I_0$) sowie der Ausgangsstrom ($I_{OUT}$; 102) des Leistungsverstärkers (1) durch Meßwertaufnehmer (12, 13, 14), deren Signalausgänge in Stern geschalten sind, einzeln erfaßt und als Rechenvariable einem Regler (ANACO; 63) zugeführt werden, der daraus nach vorgegebenen Rechenvorschriften Steuersignale (RKSP, RKSM; STRP, STRM) für die Vorspannungsquelle(n) (BAAP, BAAM; 59-62) generiert, so daß je nach Abweichung des rückgekoppelten Querstroms ($I_0$) von einem Sollwert sowie ggf. zusätzlich abhängig von der Signalfrequenz die Arbeitspunkte der Leistungs-Verstärkerelemente (PDP, PDM; 4, 5) so verstellt werden, daß die Abweichung minimiert wird, wobei das Bezugspotential (66) des Querstromreglers (63) gleich dem Potential des Sternpunkts der Meßwertaufnehmer (12, 13, 14) ist.

**36.** Verfahren nach Anspruch 35, dadurch gekennzeichnet, daß die Verstellung der Arbeitspunkte mittels Steuerung (RKSP, RKSM; STRP, STRM; SBEXP, SBEXM) der Vorspannungsquelle(n) (BAA, BAAP, BAAM, KG; 59-62) derart bewirkt wird, daß deren ausgangseitiger Gleichspannungspegel vegrößert oder verkleinert wird.

37. Verfahren nach Anspruch 35 oder 36, dadurch gekennzeichnet, daß die Vorspannungsquelle(n) (BAA, BAAP, BAAM, KG; 59-62) derart angesteuert werden, daß die komplementären Leistungsverstärkerelemente (PDP, PDM; PDEP, PDEM) in Durchlaßzustände unterschiedlichen Umfangs versetzt werden, wobei ein Leistungsverstärkerelement (PDP; PDEP) sowohl den ausgangsseitigen Laststrom ($I_{OUT}$) als auch den Querstrom ($I_0$), das andere Leistungsverstärkerelement (PDM, PDEM) nur den Querstrom ($I_0$) leitet.

## Claims

1. Electrical power amplifier (1), having a plurality of power amplifier elements (PDP, PDM; PDEP, PDEM), in particular power transistors (4, 5), which are arranged in pairs in a complementary manner on the output side in push-pull B working connections, and which on the input side (53, 54) are connected to a respective drive voltage (28, 29) influenced by the input signal (2) of the amplifier (1), and having one or more bias voltage sources (BAAP, PREAMP, BAAP, BAAM; voltage between nodes 59 and 60, and 61 and 62 respectively), which is (are) constantly coupled between the input signal (2) of the amplifier (1) and the drive voltage (28, 29) of at least one power amplifier element (PDP, PDM; PDEP, PDEM; 4, 5), in order to generate as constant as possible a quadrature current ($I_0$) flowing through the power amplifier elements (PDP, PDM; 4, 5), characterised by transducers (12, 13, 14) for detecting the currents (STRP STRM, $I_0$) flowing through the power amplifier elements (PDP, PDM; 4, 5), whose signal outputs are connected in a star, so that the currents (STRP, STRM, $I_0$) flowing through the power amplifier elements (PDP, PDM; 4, 5), and the output current ($I_{OUT}$; 102) are fed individually as arithmetic variables to a control unit (ANACO; 63), which generates therefrom according to specified computing rules control signals (RKSP, RKSM; STRP, STRM) for the bias voltage source(s) (BAAP, BAAM; 59-62) so that according to the deviation of the back-coupled quadrature current ($I_0$) from a reference value and optionally also dependent on the signal frequency the operating points of the power amplifier elements (PDP, PDM; 4, 5) are so displaced that the deviation is minimised, and the reference potential (66) of the quadrature current control unit (63) is equal to the potential of the star point of the transducers (12, 13, 14).

2. Power amplifier according to claim 1, characterised in that the bias voltage source (BAAP, BAAM) is executed in the framework of a preferably multi-stage small signal amplifier driven by the control unit (ANACO) and/or is structurally integrated therewith.

3. Power amplifier according to claim 1 or 2, characterised by two small signal amplifiers (BAAP, BAAM) which are driven by the control unit (ANACO) and which are allocated to a respective one of the power amplifier elements arranged in a complementary manner in pairs and optionally have a respective feedback from the power amplifier element (PDP, PDM).

4. Power amplifier according to claim 2 or 3, characterised in that an optionally common preamplifier (PREAMP) is connected upstream of the small signal amplifier(s) (BAAP, BAAM).

5. Power amplifier according to one of the preceding claims, characterised in that the control unit (ANACO) is coupled between the power amplifier elements (PDP, PDM) arranged in a complementary manner in pairs, in particular is interposed between the emitter-collector sections of the power transistors arranged in series and has a power signal output ($U_{OUT}$) for putting out the power amplifier output signal.

6. Power amplifier according to claim 5, characterised in that on the power signal output ($U_{OUT}$) one or more further power amplifier elements (BEXP, BEXM) and/or power amplifier element pairs (PDEP, PDEM), respectively forming a separate add-on stage (BEX) in push-pull B working connections, are connected in parallel, each power amplifier element (BEXP, BEXM, PDEP, PDEM) being driven by the control unit (ANACO).

7. Power amplifier according to claim 6, characterised in that the add-on stage (BEX) has a coupling member (KG) disposed between the power amplifier element (PDEP, PDEM) and the control unit (ANACO), which coupling member is formed as an impedance converter and/or active control element controlled by the control unit (ANACO).

8. Power amplifier according to claim 7, characterised in that the coupling member (KG) is realised as a voltage-current converter with feedback of the currents (SBEXP, SBEXM) flowing through the power amplifier element (PDEP, PDEM).

9. Power amplifier according to one of claims 6 to 8, characterised by an analogue bus (SBEXP, SBEXM), which is controlled by the control unit (ANACO) and from which one or more add-on stages (BEX) are controllable in parallel, the analogue bus (SBEXP, SBEXM) having two signal output lines passing out of the control unit, to which respectively the power amplifier elements (PDEP; PDEM) of positive or negative operating voltage are coupled for their operation.

10. Power amplifier according to claim 9, characterised in that the analogue bus (SBEXP, SBEXM) is accordingly adapted to the control unit output impedance, the characteristic impedance of its lines, and an end resistance fitted to the end of the bus line.

11. Power amplifier according to claim 9 or 10, characterised in that the two signal output lines passing out of the analogue computer (ANACO) operate according to the following equations:

$$SBEXP = STRP + 10,$$

$$SBEXM = STRM + 10,$$

STRP being the current from the power transistor PDP of the basic amplifier BAA (plus side) and STRM the current from the power transistor PDM of the basic amplifier BAA (minus side).

12. Power amplifier according to one of the preceding claims, characterised in that the control unit (ANACO) has a plurality of mutually complementary control outputs (RKSP, RKSM; STRP, STRM; SBEXP, SBEXM), which are allocated to a respective power amplifier element (PDP, PDM; PDEP, PDEM) of either positive or negative polarity.

13. Power amplifier according to one of the preceding claims, characterised in that the control unit (ANACO) comprises an analogue computer.

14. Power amplifier according to one of the preceding claims, characterised by a reference-voltage or current source (REF10) integral in the control unit (ANACO), optionally analogue computer, and a linking, in particular comparative element, which is connected to the reference source (REF10) and to the quadrature current ($I_0$) flowing through the power amplifier elements.

15. Power amplifier according to claim 14 characterised in that the control unit is realised as an analogue computer (ANACO), which in order to generate quadrature current control signals (SIOP, SIOM) has a comparative or adding member, for the power amplifier elements quadrature current ($I_0$) and the

reference current (REF10), and a multiplying member connected downstream, which is linked to a constant level (K).

16. Power amplifier according to claim 15, characterised in that the quadrature current control signal (SIOP, SIOM) is fed to a mixing stage which is linked to an amplifier wanted signal and which is optionally contained in the small signal amplifier (BAA, BAAP, BAAM).

17. Power amplifier according to one of the preceding claims, characterised in that the control unit is realised as an analogue computer (ANACO) which has, for generating feedback signals (RKSP, RKSM), a multiplying member coupled at a constant level (K) for the current (STRP, STRM) flowing through a power amplifier element, and a downstream adding member for the power amplifier output signal ($U_{OUT}$).

18. Power amplifier according to one of claims 1 to 16, characterised in that the control unit is realised as an analogue computer (ANACO), which has a logic switching element wired to generate feedback signals (RKSP, RKSM) which are dependent on the power amplifier output signal ($U_{OUT}$, $I_{OUT}$) and/or the quadrature current reference value deviation or a corresponding fault voltage.

19. Power amplifier according to claim 15 and one of the other claims, characterised in that the control unit is realised as an analogue computer (ANACO), which for generating feedback signals (RKSP, RKSM) has an adding member, which is connected to the power amplifier output signal ($I_{OUT}$, $U_{OUT}$) and the quadrature current control signal (SIOP, SIOM).

20. Power amplifier according to claim 2, 3 or 4 and one of claims 17, 18 or 19, characterised in that the feedback signal (RKSP, RKSM) is supplied to the small signal amplifier (BAA, BAAP, BAAM).

21. Power amplifier according to claim 10, characterised in that the control unit is realised as an analogue computer (ANACO), which for generating analogue bus output signals (SBEXP, SBEEM) is provided with an adding member for the power amplifier elements quadrature current ($I_0$) and the current (STRP, STRM) flowing through a power amplifier element and optionally with a downstream multiplying member, which is coupled to a constant level (A1, A2).

22. Power amplifier according to one of the preceding claims, characterised in that the control unit is realised as an analogue computer (ANACO), which has a computer circuit for the power loss of the power amplifier elements (PDP, PDM; PDEP, PDEM), which drives a device for protecting against overload of the power amplifier elements.

23. Electric power amplifier (1) according to one of the preceding claims, characterised in that the transducers are ohmic resistors (12, 13, 14) connected into the respective circuit.

24. Power amplifier according to claim 23, characterised in that the free connections of the transducers (12, 13, 14) are connected to the outputs (10, 11) of the power amplifier elements (4, 5) on one side and to the output (3) of the power amplifier (1) on the other.

25. Power amplifier according to claim 24, characterised by supply voltages (64, 65) for the quadrature current control unit (63) which are constant relative to the potential of the star point of the transducers (12, 13, 14).

26. Power amplifier according to one of the preceding claims, characterised by an analogue circuit (67 - 93) inside the quadrature current control unit (63), which forms from the measurement signals (10, 11, 3) for the currents flowing through the power amplifier elements (4, 5) and of the output current (102) of the power amplifier (1) an arithmetic signal proportional to the quadrature current.

27. Power amplifier according to claim 26, characterised by a subtraction circuit (69 - 73) for generating the difference between the arithmetic signal proportional to the quadrature current and a constant quadrature current reference value (68).

28. Power amplifier according to claim 27, characterised in that in order to generate the control unit output signal, the arithmetic signal (90, 93) proportional to the difference between the quadrature current reference and actual values is multiplied by a factor, is in particular amplified.

29. Power amplifier according to claim 28, characterised in that in order to generate the drive signal for one of the power amplifier elements (4, 5) the output signal (59 - 62) of the quadrature current control unit (63) is additively or subtractively superimposed on the optionally preamplified amplifier input signal or the output signal (37, 38) of a higher-voltage voltage control unit (15).

30. Power amplifier according to claim 29, characterised in that in order to generate the drive signal for the other power amplifier element (5; 4) the output signal (59 - 62) of the quadrature current control unit (63) is superimposed on the optionally preamplified input signal or the output signal (37, 38) of a superordinate voltage control unit (15) with reverse polarity.

31. Power amplifier according to claim 29 or 30, characterised by separate drive stages (28, 29) for the two power amplifier elements (4, 5).

32. Power amplifier according to claim 31, characterised in that the output transistor(s) (41, 42, 46, 47) of the drive stage(s) (28, 29) coupled to the output signal (59 - 62) of the quadrature current control unit (63) are operated in emitter circuit and the superposition of amplifier input and quadrature current control unit output signals (59 - 62) is effected by negative current feedback by way of an emitter resistor (55, 56, 57, 58), which is connected in the emitter circuit of this transistor (41, 42, 46, 47) and which in addition to the emitter current of the drive transistor (41, 42, 46, 47) conducts a control current proportional to the output signal (59 - 62) of the quadrature current control unit (63).

33. Power amplifier according to claim 32, characterised in that the arithmetic signal (90, 93) proportional to the difference between the quadrature current reference (68) and actual values is amplified in a differential amplifier (100, 101), one of whose collector resistors is identical to the emitter resistor (55, 56, 57, 58) of the drive stage for providing negative current feedback.

34. Power amplifier according to claim 33, characterised in that each drive stage (28, 29) is formed from two complementary transistors (41, 46; 42, 47) arranged in emitter connection and operated in push-pull manner, each with an emitter resistor (55, 57; 56, 58), these emitter resistors (55, 57; 56, 58) being identical to the collector resistors of a respective branch (59, 61; 60, 62) of two differential amplifiers (100, 101) arranged symmetrically to the reference potential (66) of the quadrature current control unit (63).

35. Method of operating an electric power amplifier (1), in particular according to one of the preceding claims, which has a plurality of power amplifier elements (PDP, PDM; PDEP, PDEM), in particular power transistors (4, 5), which on the output side are arranged in pairs in a complementary manner in push-pull B operating connection, and which on the input side (53, 54) are connected to a respective drive voltage (28, 29) influenced by the input signal (2) of the amplifier (1), and having one or more bias voltage sources (BAA, BAAP, BAAM; voltage between nodes 59 and 60, and 61 and 62 respectively), which is (are) constantly coupled between the input signal (2) of the amplifier (1) and the drive voltage (28, 29) of at least one power amplifier element (PDP, PDM; 4, 5), in order to generate as constant as possible a quadrature current ($I_0$) flowing through the power amplifier elements (PDP, PDM; 4, 5), characterised in that the currents (STRP, STRM, $I_0$) flowing through the power amplifier elements (PDP, PDM; 4, 5) and the output current ($I_{OUT}$; 102) of the power amplifier (1) are individually determined by transducers (12, 13, 14) - whose signal outputs are in a star connection - and are supplied as arithmetic variables to a control unit (ANACO; 63), which therefrom generates according to specified computing rules control signals (RKSP, RKSM; STRP, STRM) for the bias voltage source (s) (BAAP, BAAM; 59-62), so that according to the deviation of the back-coupled quadrature current ($I_0$) from a reference value and optionally additionally dependent on the signal frequency of the operating points of the power amplifier elements (PDP, PDM; 4, 5) are so displaced that the deviation is minimised, the reference potential (66) of the quadrature current (63) being equal to the potential of the star point of the transducers (12, 13, 14).

36. Method according to claim 35, characterised in that the displacement of the operating points by means of control (RKSP, RKSM; STRP, STRM; SBEXP, SBEXM) of the bias voltage source(s) (BAA, BAAP, BAAM, KG; 59-62) is so effected that their output-side direct voltage level is increased or reduced.

37. Method according to claim 35 or 36, characterised in that the bias voltage source(s) (BAA, BAAP, BAAM, KG; 59-62) are so driven that the complementary power amplifier elements (PDP, PDM; PDEP, PDEM) are moved into transmission states of different sizes, and one power amplifier element (PDP; PDEP) conducts both the output-side load current ($I_{OUT}$) and the quadrature current ($I_0$), whilst the other power amplifier element (PDM, PDEM) conducts only the quadrature current ($I_0$).

**Revendications**

1. Amplificateur électrique de puissance (1) comportant plusieurs éléments amplificateurs de puissance (PDP, PDM; PDEP, PDEM), notamment des transistors de puissance (4,5), qui côté sortie, sont disposés, d'une manière complémentaire entre eux par couples, selon un montage symétrique fonctionnant en classe B, et qui, côté entrée (53,54), sont placés à des tensions respectives de commande (28,29) influencées par le signal d'entrée (2) de l'amplificateur (1), ainsi qu'une ou plusieurs sources de tension de polarisation (BAA, PREAMP, BAAP, BAAM; tension entre les noeuds 59 et 60 ou 61 et 62), qui est connectée (sont connectées) en permanence entre le signal d'entrée (2) de l'amplificateur (1) et la tension de commande (28,29) d'au moins un élément amplificateur de puissance (PDP, PDM; PDEP, PDEM; 4,5), pour produire un courant transversal ($I_0$) aussi constant que possible, qui circule dans les éléments amplificateurs de puissance (PDP, PDM; 4,5), caractérisé par des transducteurs de mesure (12,13,14) qui servent à détecter les courants (STRP, STRM, $I_0$) circulant dans les éléments amplificateurs de puissance (PDP, PDM; 4,5) et dont les sorties de signaux sont branchées en étoile, pour que les courants (STRP, STRM, $I_0$), circulant dans les éléments amplificateurs de puissance (PDP, PDM; 4,5), et le courant de sortie ($I_{OUT}$; 102) soient envoyés individuellement, en tant que variables de calcul, à un régulateur (ANACO; 63), qui engendre à partir de là, conformément à des prescriptions de calcul prédéterminées, des signaux de commande (RKSP, RKSM; STRP, STRM) pour la ou les sources de tension de polarisation (BAAP, BAAM; 59-62), afin que, en fonction de chaque écart entre le courant transversal ($I_0$) réinjecté et une valeur de consigne ainsi que, éventuellement en plus, en fonction de la fréquence du signal, les points de fonctionnement des éléments amplificateurs de puissance (PDP, PDM; 4,5) soient décalés de telle sorte que l'écart soit réduit à un minimum, le potentiel de référence (66) du régulateur (63) du courant transversal étant alors égal au potentiel du centre du montage en étoile des transducteurs de mesure (12,13,14).

2. Amplificateur de puissance selon la revendication 1, caractérisé en ce que la source de tension de polarisation (BAAP, BAAM) est aménagée au sein d'un amplificateur de petits signaux de préférence à plusieurs étages, commandé par le régulateur (ANACO), et/ou est intégrée structurellement dans cet amplificateur.

3. Amplificateur de puissance selon la revendication 1 ou 2, caractérisé par deux amplificateurs de petits signaux (BAAP, BAAM), qui sont commandés par le régulateur (ANACO) et qui sont associés respectivement à l'un des éléments amplificateurs de puissance (PDP, PDM) complémentaires par couples, et possèdent éventuellement chacun une réaction partant de l'élément amplificateur de puissance (PDP, PDM).

4. Amplificateur de puissance selon la revendication 2 ou 3, caractérisé en ce que, en amont du ou des amplificateurs de petits signaux (BAAP, BAAM), est branché un préamplificateur (PREAMP), éventuellement commun.

5. Amplificateur de puissance selon l'une des revendications précédentes, caractérisé en ce que le régulateur (ANACO) est connecté entre les éléments amplificateurs de puissance (PDP, PDM) complémentaires par couples, et notamment est intercalé entre les voies émetteur - collecteur, placées en série, des transistors de puissance, et comporte une sortie ($U_{OUT}$) de signaux de puissance pour délivrer le signal de sortie de l'amplificateur de puissance.

6. Amplificateur de puissance selon la revendication 5, caractérisé en ce que sur la sortie ($U_{OUT}$) des signaux de puissance, sont branchés en parallèle un ou plusieurs autres éléments amplificateurs de puissance (BEXP, BEXM) et/ou couples d'éléments amplificateurs de puissance (PDEP, PDEM), formant des étages respectifs séparés d'extension (BEX) suivant un montage symétrique fonctionnant en classe B, chaque élément amplificateur de puissance (BEXP, BEXM, PDEP, PDEM) étant commandé par le régulateur (ANACO).

7. Amplificateur de puissance selon la revendication 6, caractérisé en ce que l'étage d'extension (BEX) comporte un circuit de couplage (KG), qui est disposé entre l'élément amplificateur de puissance (PDEP, PDEM) et le régulateur (ANACO) et qui est conçu sous la forme d'un convertisseur d'impédance et/ou d'un élément de commande actif contrôlé par le régulateur (ANACO).

8. Amplificateur de puissance selon la revendication 7, caractérisé en ce que le circuit de couplage (KG) est réalisé sous la forme d'un convertisseur tension - courant avec réinjection des courants (SBEXP, SBEXM) circulant dans l'élément amplificateur de puissance (PDEP, PDEM).

9. Amplificateur de puissance selon l'une des revendications 6 à 8, caractérisé par un bus analogique (SBEXP, SBEXM), qui est contrôlé par le régulateur (ANACO) et à partir duquel peuvent être commandés en parallèle un ou plusieurs étages d'extension (BEX), le bus analogique (SBEXP, SBEXM) comportant deux lignes de sortie de signaux, qui sortent du régulateur et auxquelles sont accouplés, pour leur commande, les éléments amplificateurs respectifs de puissance (PDEP; PDEM) présentant une tension de fonctionnement positive ou négative.

10. Amplificateur de puissance selon la revendication 9, caractérisé en ce que le bus analogique (SBEXP, SBEXM) est adapté, en fonction de l'impédance de sortie du régulateur, à l'impédance caractéristique de ses lignes et à une résistance de terminaison incorporée à l'extrémité de la ligne formant bus.

11. Amplificateur de puissance selon la revendication 9 ou 10, caractérisé en ce que les deux lignes de sortie de signaux, qui partent du calculateur analogique (ANACO), travaillent conformément aux équations suivantes :

$$SBEXP = STRP + I0,$$

$$SBEXM = STRM + I0$$

STRP désignant le courant partant du transistor de puissance PDP de l'amplificateur de base BAA (côté plus) et STRM désignant le courant partant du transistor de puissance PDM de l'amplificateur de base BAA (côté moins).

12. Amplificateur de puissance selon l'une des revendications précédentes, caractérisé en ce que le régulateur (ANACO) comporte plusieurs sorties de commande complémentaires l'une de l'autre (RKSP, RKSM; STRP, STRM; SBEXP, SBEXM), qui sont associées chacune à un élément amplificateur de puissance (PDP, PDM; PDEP, PDEM) présentant une polarité soit positive, soit négative.

13. Amplificateur de puissance selon l'une des revendications précédentes, caractérisé en ce que le régulateur (ANACO) comprend un calculateur analogique.

14. Amplificateur de puissance selon l'une des revendications précédentes, caractérisé par une source de tension ou de courant de référence (REFIO) intégrée dans le régulateur (ANACO), le cas échéant le calculateur analogique, et par un élément combinatoire, notamment un élément comparateur, qui est connecté à la source de référence (REFIO) et au courant (transversal) ($I_0$) circulant dans les éléments amplificateurs de puissance.

15. Amplificateur de puissance selon la revendication 14, caractérisé en ce que le régulateur est réalisé sous la forme d'un calculateur analogique (ANACO), qui comporte, pour la production de signaux de commande de courant transversal (SIOP, SIOM), un circuit comparateur ou un circuit additionneur pour le courant transversal ($I_0$) des éléments amplificateurs de puissance et le courant de référence (REFIO) et un circuit multiplicateur branché en aval, qui est combiné à un niveau constant (K).

16. Amplificateur de puissance selon la revendication 15, caractérisé en ce que le signal de commande de courant transversal (SIOP, SIOM) est envoyé à un étage mélangeur combiné à un signal utile d'amplificateur, qui est éventuellement contenu dans l'amplificateur de petits signaux (BAA, BAAP, BAAM).

17. Amplificateur de puissance selon l'une des revendications précédentes, caractérisé en ce que le régulateur est réalisé sous la forme d'un calculateur analogique (ANACO), qui comporte, pour la production de signaux de réaction (RKSP, RKSM), un circuit multiplicateur couplé à un niveau constant (K), pour le courant (STRP, STRM) circulant dans un élément amplificateur de puissance, et un circuit additionneur branché en aval, pour le signal de sortie (U$_{OUT}$) de l'amplificateur de puissance.

18. Amplificateur de puissance selon l'une des revendications 1 à 16, caractérisé en ce que le régulateur est réalisé sous la forme d'un calculateur analogique (ANACO), qui possède un dispositif combinatoire qui est conçu pour la production de signaux de réaction (RKSP, RKSM), qui sont produits en fonction du signal de sortie (U$_{OUT}$, I$_{OUT}$) de l'amplificateur de puissance et/ou de l'écart par rapport à la valeur de consigne du courant transversal, ou d'une tension d'erreur correspondante.

19. Amplificateur de puissance selon la revendication 15 et l'une des autres revendications, caractérisé en ce que le régulateur est réalisé sous la forme d'un calculateur analogique (ANACO) qui possède, pour la production de signaux de réaction (RKSP, RKSM), un circuit additionneur qui est relié au signal de sortie (I$_{OUT}$, U$_{OUT}$) de l'amplificateur de puissance et au signal de commande de courant transversal (SIOP, SIOM).

20. Amplificateur de puissance selon la revendication 2, 3 ou 4, et l'une des revendications 17, 18 ou 19, caractérisé en ce que le signal de réaction (RKSP, RKSM) est envoyé à l'amplificateur de petits signaux (BAA, BAAP, BAAM).

21. Amplificateur de puissance selon la revendication 10, caractérisé en ce que le régulateur est réalisé sous la forme d'un calculateur analogique (ANACO), qui, pour la production de signaux de sortie (SBEXP, SBEXM) du bus analogique, est équipé d'un circuit additionneur pour le courant transversal (10) des éléments amplificateurs de puissance et pour le courant (STRP, STRM) qui circule dans un élément amplificateur de puissance, et éventuellement d'un circuit multiplicateur branché en aval, qui est couplé à un niveau constant (A1, A2).

22. Amplificateur de puissance selon l'une des revendications précédentes, caractérisé en ce que le régulateur est réalisé sous la forme d'un calculateur analogique (ANACO), qui comporte un circuit de calcul de la perte de puissance des éléments amplificateurs de puissance (PDP, PDM; PDEP, PDEM), qui commande un dispositif servant à réaliser une protection des éléments amplificateurs de puissance vis-à-vis d'une surcharge.

23. Amplificateur électrique de puissance (1) selon l'une des revendications précédentes, caractérisé en ce que les transducteurs de mesure sont des résistances ohmiques (12,13,14) insérées dans les circuits de courant respectifs.

24. Amplificateur de puissance selon la revendication 23, caractérisé en ce que les bornes libres des résistances de mesure (12,13,14) sont reliées, d'une part, aux sorties (10,11) des éléments amplificateurs de puissance (4,5) ainsi que, d'autre part, à la sortie (3) de l'amplificateur de puissance (1).

25. Amplificateur de puissance selon la revendication 24, caractérisé par des tensions d'alimentation (64,65) pour le régulateur (63) du courant transversal, qui sont constantes par rapport au potentiel, utilisé comme potentiel de référence (66), du centre du montage en étoile des transducteurs de mesure (12,13,14).

26. Amplificateur de puissance selon l'une des revendications précédentes, caractérisé par un circuit analogique (67 - 93) situé à l'intérieur du régulateur (63) du courant transversal, qui élabore un signal de calcul proportionnel au courant transversal, à partir des signaux de mesure (10, 11,3) pour les courants circulant dans les éléments amplificateurs de puissance (4,5) ainsi que le courant de sortie (102) de l'amplificateur de puissance (1).

27. Amplificateur de puissance selon la revendication 26, caractérisé par un circuit soustracteur (69-73) pour former la différence entre le signal de calcul, proportionnel au courant transversal, et une valeur de consigne constante (68) du courant transversal.

28. Amplificateur de puissance selon la revendication 27, caractérisé en ce que pour la formation du signal de sortie du régulateur, le signal de calcul (90,93), qui est proportionnel à la différence entre la valeur de consigne et la valeur réelle du courant transversal, est multiplié, notamment amplifié, par un facteur.

29. Amplificateur de puissance selon la revendication 28, caractérisé en ce que le signal de sortie (59-62) du régulateur (63) du courant transversal est superposé, par addition ou soustraction, au signal d'entrée de l'amplificateur, le cas échéant préamplifié, ou au signal de sortie (37,38) d'un régulateur de tension (15) placé à un niveau supérieur, pour la formation du signal de commande pour l'un des éléments amplificateurs de puissance (4,5).

30. Amplificateur de puissance selon la revendication 29, caractérisé en ce que le signal de sortie (59-62) du régulateur (63) du courant transversal est superposé, avec une polarité inversée, au signal d'entrée, le cas échéant préamplifié, ou au signal de sortie (37,38) d'un régulateur de tension (15) placé à un niveau supérieur, pour la formation du signal de commande pour l'autre élément amplificateur de puissance (5;4).

31. Amplificateur de puissance selon la revendication 29 ou 30, caractérisé par des étages de commande séparés (28,29) pour les deux éléments amplificateurs de puissance (4,5).

32. Amplificateur de puissance selon la revendication 31, caractérisé en ce que le ou les transistors de sortie (41,42,46,47) du ou des étages de commande (28,29) couplés au signal de sortie (59-62) du régulateur (63) du courant transversal, fonctionnent selon un montage en émetteur commun et la superposition du signal d'entrée de l'amplificateur et du signal de sortie du régulateur du courant transversal (59-62) s'effectue par contre-réaction de courant à l'aide d'une résistance d'émetteur (55,56,57,58) branchée dans le circuit d'émetteur de ce transistor (41,42,46,47) et qui véhicule, en plus du courant d'émetteur du transistor de commande (41,42,46,47), un courant de régulation proportionnel au signal de sortie (59-62) du régulateur (63) du courant transversal.

33. Amplificateur de puissance selon la revendication 32, caractérisé en ce que le signal de calcul (90,93), qui est proportionnel à la différence entre la valeur de consigne (68) et la valeur réelle du courant transversal, est amplifié dans un amplificateur différentiel (100, 101), dont l'une des résistances de collecteur est identique à la résistance d'émetteur (55,56,57,58), qui est utilisée pour la contre-réaction de courant, de l'étage de commande.

34. Amplificateur de puissance selon la revendication 33, caractérisé en ce que chaque étage de commande (28,29) est constitué de deux transistors complémentaires (41,46;42,47) qui sont montés en émetteur commun et fonctionnent de façon symétrique et qui comportent chacun une résistance d'émetteur (55,57; 56,58), ces résistances d'émetteur (55,57; 56,58) étant identiques aux résistances de collecteur d'une branche respective (59,61; 60,62) de deux amplificateurs différentiels (100,101) disposés symétriquement par rapport au potentiel de référence (66) du régulateur (63) du courant transversal.

35. Procédé pour faire fonctionner un amplificateur électrique de puissance (1), notamment selon l'une des revendications précédentes, qui comporte plusieurs éléments amplificateurs de puissance (PDP, PDM; PDEP, PDEM), notamment des transistors de puissance (4,5), qui, côté sortie, sont disposés d'une manière complémentaire entre eux par couples, selon un montage symétrique fonctionnant en classe B et qui, côté entrée (53,54) sont placés à des tensions respectives de commande (28,29) influencées par le signal d'entrée (2) de l'amplificateur (1), ainsi qu'une ou plusieurs sources de tension de polarisation (BAA, BAAP, BAAM; tension entre les noeuds 59 et 60 ou 61 et 62), qui est connectée (sont connectées) en permanence entre le signal d'entrée (2) de l'amplificateur (1) et la tension de commande (28,29) d'au moins un élément amplificateur de puissance (PDP, PDM; 4,5), pour produire un courant transversal ($I_0$) aussi constant que possible, qui circule dans les éléments amplificateurs de puissance (PDP, PDM; 4,5), caractérisé en ce que les courants (STRP, STRM, $I_0$) qui circulent dans les éléments amplificateurs de puissance (PDP, PDM; 4,5) ainsi que le courant de sortie ($I_{OUT}$; 102) de l'amplificateur de puissance (1) sont détectés individuellement par des transducteurs de mesure (12,13,14), dont les sorties de signaux sont branchées en étoile, et sont envoyés, en tant que variables de calcul, à un régulateur (ANACO; 63), qui engendre à partir de là, conformément à des prescriptions de calcul prédéterminées, des signaux de commande (RKSP, RKSM; STRP, STRM) pour la ou les sources de tension de polarisation (BAAP, BAAM; 59-62), pour qu'en fonction de chaque écart entre le courant transversal ($I_0$) réinjecté et une valeur de consigne ainsi qu'en outre éventuellement en fonction de la fréquence du signal, les points de fonctionnement des éléments amplificateurs de puissance (PDP, PDM; 4,5) soient décalés de telle sorte que l'écart soit réduit à un minimum, le potentiel de référence (66) du régulateur (63) du courant transversal étant alors égal au potentiel du centre du montage en étoile des transducteurs de mesure (12,13,14).

36. Procédé selon la revendication 35, caractérisé en ce que le décalage des points de fonctionnement est réalisé au moyen d'une commande (RKSP, RKSM; STRP, STRM; SBEXP, SBEXM) de la ou des sources de tension de polarisation (BAA, BAAP, BAAM, KG; 59-62), de telle sorte que le niveau de tension continue, côté sortie, de ces dernières soit augmenté ou diminué.

37. Procédé selon la revendication 35 ou 36, caractérisé en ce que la ou les sources de tension de polarisation (BAA, BAAP, BAAM, KG; 59-62) sont commandées de telle sorte que les éléments amplificateurs de puissance complémentaires (PDP, PDM; PDEP,PDEM) soient placés dans des états passants d'ampleurs différentes, un élément amplificateur de puissance (PDP; PDEP) conduisant alors aussi bien le courant de charge ($I_{OUT}$) côté sortie que le courant transversal ($I_0$), tandis que l'autre élément amplificateur de puissance (PDM, PDEM) conduit uniquement le courant transversal ($I_0$).

FIG. 1

FIG. 2

FIG. 3

EP 0 687 397 B1

FIG. 4

**FIG. 5**

**FIG. 6**

FIG. 7

FIG. 8

FIG. 9

EP 0 687 397 B1